# EUROPEAN PATENT APPLICATION

(11) **EP 3 547 807 A1**
(43) Date of publication of application: **02.10.2019**
(21) Application number: 17873195.6
(22) Date of filing: 08.11.2017
(51) Int. Cl.: H05K 1/14, H05K 1/11, H05K 3/34

(54) **THREE-DIMENSIONAL PRINTED WIRING BOARD AND METHOD FOR MANUFACTURING SAME**

(30) Priority: 28.11.2016 JP 2016230003
(71) Applicant: Mitsubishi Electric Corporation, Chiyoda-ku Tokyo 100-8310 (JP)
(72) Inventor: SHIGETA, Koji, Tokyo 100-8310 (JP); SASAKI, Shunsuke, Tokyo 100-8310 (JP)
(74) Representative: Trinks, Ole
(86) International application number: PCT/JP2017/040239
(87) International publication number: WO 2018/096927

(57) **Abstract**

A three-dimensional printed wiring board (100) includes a main substrate (1) and a standing substrate (2). First electrodes on the main substrate (1) and second electrodes (12) on the standing substrate (2) are joined with solder. The main substrate (1) includes a first main surface having a slit (3). The standing substrate (2) includes a second main surface and includes a support portion (4) inserted in the slit (3). Each of the slit (3) and the support portion (4) is divided into a plurality of parts with respect to the extending direction. A restraint point (7) at which the slit (3) and the standing substrate (2) are in contact with each other is located on any of end portions (3e3) of a pair of slits (3a, 3b) adjacent to each other among a row of a plurality of slits (3) arranged in the extending direction.

## Description

### TECHNICAL FIELD

The present invention relates to a three-dimensional printed wiring board and a method for manufacturing the same, and more particularly to a three-dimensional printed wiring board in which a standing substrate is fixed to a main substrate substantially perpendicularly thereto and in which the wiring pattern on the main substrate and the wiring pattern on the standing substrate are electrically connected to each other, and to a method for manufacturing the same.

### BACKGROUND ART

Downsizing of a three-dimensional printed wiring board has been achieved by providing a slit through a main substrate, inserting a standing substrate in the slit substantially perpendicularly thereto, and soldering these substrates together to form a three-dimensional printed wiring board. Such a configuration is disclosed in, for example, Japanese Patent Laying-Open No. 2008-171849 (PTL 1). In Japanese Patent Laying-Open No. 2008-171849, an auxiliary substrate is provided for allowing self-support of and reinforcing the standing substrate.

### CITATION LIST

### PATENT LITERATURE

PTL 1: Japanese Patent Laying-Open
JP 2008-171849 A

### SUMMARY OF INVENTION

### TECHNICAL PROBLEM

Assumably, the slit in the main substrate in Japanese Patent Laying-Open No. 2008-171849 is designed a little larger than a necessary dimension, taking account of variations in thickness of the standing substrate and variations in machining dimension of the slit width. Accordingly, when the standing substrate is inserted in the slit in the main substrate, there is a clearance between the slit and the standing substrate. Due to this clearance, when the main substrate and the standing substrate are flow- soldered, the jet stream of molten solder forces the standing substrate to move rearward relative to the main substrate (where the direction in which the substrate is transferred by the stream is defined as the forward direction). Thus, the standing substrate touches and interferes with the slit at the rearmost position of the slit with respect to the above-described transfer direction. That is, the standing substrate is restrained by the slit at the rearmost position of the slit.

If the standing substrate comes into contact with, restrained by, and fixed to the rearmost end portion of the slit in the main substrate, breakage will occurs in a short time at the solder joint portion between electrodes on the two substrates at the front end portion, remotest from the rearmost end portion, due to thermal distortion caused by temperature cycle under the use environment. This is because the thermal distortion of the solder joint portion increases with distance from the restraint point at which the substrate is restrained and fixed. Japanese Patent Laying-Open No. 2008-171849, however, does not disclose any means to address such a problem.

The present invention has been made in view of the above-described problem, and an object of the present invention is to provide a three-dimensional printed wiring board and a method for manufacturing the same that, when there is a clearance between a slit and a standing substrate, can prevent breakage of a solder joint portion due to thermal distortion caused by temperature cycle under the use environment and can prolong the life of the solder joint portion.

### SOLUTION TO PROBLEM

A three-dimensional printed wiring board of the present invention includes a main substrate and a standing substrate. First electrodes on the main substrate and second electrodes on the standing substrate are joined with solder. The main substrate includes a first main surface having a slit. The standing substrate includes a second main surface and includes a support portion inserted in the slit. Each of the slit and the support portion is divided into a plurality of parts with respect to the extending direction. A restraint point at which the slit and the standing substrate are in contact with each other is located on any of end portions of a pair of slits adjacent to each other among a row of a plurality of slits arranged in the extending direction.

In a method for manufacturing a three-dimensional printed wiring board of the present invention, a main substrate and a standing substrate are prepared. First electrodes on the main substrate and second electrodes on the standing substrate are joined by flow soldering. A slit is formed in a first main surface of the main substrate. The standing substrate includes a second main surface, and a support portion to be inserted in the slit is formed in the standing substrate. Each of the slit and the support portion is divided into a plurality of parts with respect to the extending direction. In the flow soldering, the standing substrate and the main substrate are transferred while the main substrate and the standing substrate are placed in such a manner that the extending direction of the slit is along a transfer direction of the main substrate and the standing substrate. Thus, a restraint point is formed, at which the slit and the standing substrate are in contact with each other, on any of end portions of a pair of the slits adjacent to each other among a row of a plurality of the slits arranged in the extending direction.

A three-dimensional printed wiring board of the present invention includes a main substrate and a standing substrate. First electrodes on the main substrate and second electrodes on the standing substrate are joined with solder. The main substrate includes a first main surface having a slit. The standing substrate includes a second main surface and includes a support portion inserted in the slit. The main substrate has a plurality of through holes in a region adjacent to the plurality of first electrodes, the plurality of through holes extending through the main substrate from the one first main surface to the other first main surface. Each of the plurality of through holes has an inner wall with a conductor film formed thereon.

### ADVANTAGEOUS EFFECTS OF INVENTION

According to the present invention, the restraint point between the slit and the standing substrate can be located between one end portion and the other end portion with respect to the extending direction of the slit. This can reduce the thermal distortion of the restraint point and the solder joint portion at the electrode remotest from the restraint point, compared to the case in which the restraint point is located, for example, at one end portion of the whole of a plurality of arranged slits. Thus, the life of the solder joint portion can be prolonged.

### BRIEF DESCRIPTION OF DRAWINGS

- Fig. 1: is a schematic perspective view showing, in external appearance, the configuration of a three-dimensional printed wiring board in embodiment 1.
- Fig. 2: is a schematic front view showing the configuration of the three-dimensional printed wiring board in Fig. 1 as seen from direction II indicated by the arrow in Fig. 1.
- Fig. 3: is a schematic cross-sectional view taken along line III-III in Fig. 1.
- Fig. 4: is a schematic plan view of a main substrate constituting the three-dimensional printed wiring board in embodiment 1.
- Fig. 5: is a schematic plan view (A) of a standing substrate constituting the three-dimensional printed wiring board in embodiment 1, as seen from one second main surface side; and a schematic plan view (B) of a standing substrate constituting the three-dimensional printed wiring board in embodiment 1, as seen from the other second main surface side.
- Fig. 6: is a schematic front view showing one process in a method for manufacturing the three-dimensional printed wiring board in embodiment 1.
- Fig. 7: is a schematic front view showing a process that follows Fig. 6 in the method for manufacturing the three-dimensional printed wiring board in embodiment 1, and showing an external appearance of a finished product of the three-dimensional printed wiring board.
- Fig. 8: is a schematic plan view of a main substrate constituting a three-dimensional printed wiring board in a comparative example.
- Fig. 9: is a schematic plan view (A) of a standing substrate constituting the three-dimensional printed wiring board in the comparative example, as seen from one second main surface side; and a schematic plan view (B) of a standing substrate constituting the three-dimensional printed wiring board in the comparative example, as seen from the other second main surface side.
- Fig. 10: is a schematic front view showing one process in a method for manufacturing the three-dimensional printed wiring board in the comparative example, and showing the positional relationship between the restraint point and the maximum distortion soldering portion.
- Fig. 11: is a schematic front view showing the positional relationship between the restraint point and the maximum distortion soldering portion in the three-dimensional printed wiring board in embodiment 1.
- Fig. 12: is a schematic front view comparing the comparative example in Fig. 10 and embodiment 1 in Fig. 11 in terms of the restraint point and the maximum distortion soldering portion.
- Fig. 13: is a schematic front view showing one process in a method for manufacturing a three-dimensional printed wiring board in a first variation of embodiment 1.
- Fig. 14: is a schematic front view showing one process in a method for manufacturing a three-dimensional printed wiring board in a second variation of embodiment 1.
- Fig. 15: is a schematic diagram (A) showing a first example of the relationship between the dimension and the position of the slit and the support portion, a schematic diagram (B) showing a second example of the relationship, and a schematic diagram (C) showing a third example of the relationship, for summarizing embodiment 1.
- Fig. 16: is a schematic plan view of a main substrate constituting a three-dimensional printed wiring board in embodiment 2.
- Fig. 17: is a schematic plan view (A) of a standing substrate constituting the three-dimensional printed wiring board in embodiment 2, as seen from one second main surface side; and a schematic plan view (B) of a standing substrate constituting the three-dimensional printed wiring board in embodiment 1, as seen from the other second main surface side.
- Fig. 18: is a schematic front view showing one process in a method for manufacturing the three-dimensional printed wiring board in embodiment 2.
- Fig. 19: is a schematic front view showing a process that follows Fig. 18 in the method for manufacturing the three-dimensional printed wiring board in embodiment 2, and showing an external appearance of a finished product of the three-dimensional printed wiring board.
- Fig. 20: is a schematic front view showing one process in a method for manufacturing a three-dimensional printed wiring board in a variation of embodiment 2.
- Fig. 21: is a schematic diagram (A) showing a first example of the relationship between the dimension and the position of the slit and the support portion, a schematic diagram (B) showing a second example of the relationship, and a schematic diagram (C) showing a third example of the relationship, for summarizing embodiment 2.
- Fig. 22: is a schematic plan view of a main substrate constituting a three-dimensional printed wiring board in embodiment 3.
- Fig. 23: is a schematic plan view (A) of a standing substrate constituting the three-dimensional printed wiring board in embodiment 3, as seen from one second main surface side; and a schematic plan view (B) of a standing substrate constituting the three-dimensional printed wiring board in embodiment 1, as seen from the other second main surface side.
- Fig. 24: is a schematic front view showing one process in a method for manufacturing the three-dimensional printed wiring board in embodiment 3, and showing an external appearance of a finished product of the three-dimensional printed wiring board.
- Fig. 25: is a schematic plan view of a main substrate constituting a three-dimensional printed wiring board in embodiment 4.
- Fig. 26: is a schematic front view showing a process that follows Fig. 6 in a method for manufacturing the three-dimensional printed wiring board in embodiment 4, and showing an external appearance of a finished product of the three-dimensional printed wiring board.
- Fig. 27: is a schematic plan view of a main substrate constituting a three-dimensional printed wiring board in a first variation of embodiment 4.
- Fig. 28: is a schematic plan view of a main substrate constituting a three-dimensional printed wiring board in a second variation of embodiment 4.
- Fig. 29: is a schematic plan view of a main substrate constituting a three-dimensional printed wiring board in a third variation of embodiment 4.
- Fig. 30: is a schematic front view showing a process that follows Fig. 6 in a method for manufacturing the three-dimensional printed wiring board in the third variation of embodiment 4, and showing an external appearance of a finished product of the three-dimensional printed wiring board.

### DESCRIPTION OF EMBODIMENTS

Embodiments of the present invention are hereinafter described with reference to the drawings.

### Embodiment 1

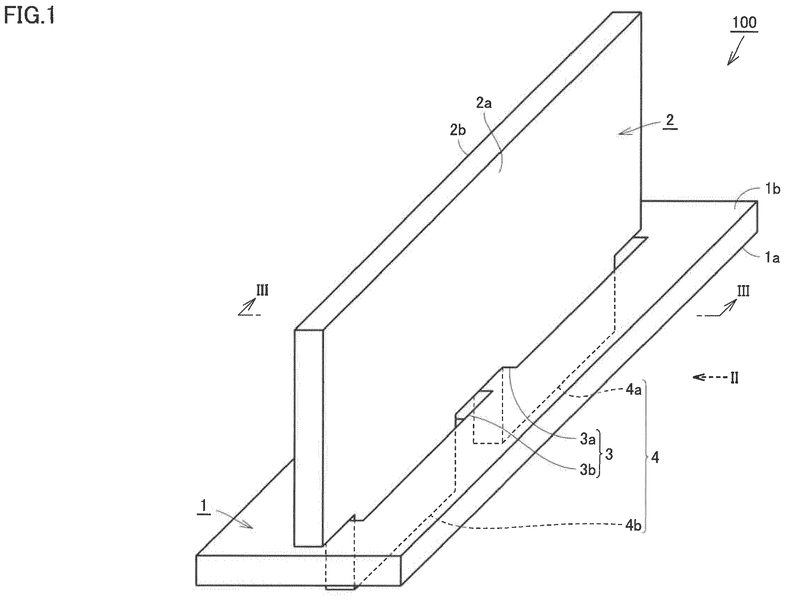

First, the configuration of a three-dimensional printed wiring board in the present embodiment is described with reference to Fig. 1 to Fig. 5.

Fig. 1 is a diagram showing the overall structure of a three-dimensional printed wiring board 100 in the present embodiment. With reference to Fig. 1, three-dimensional printed wiring board 100 in the present embodiment includes a main substrate 1 and a standing substrate 2. Main substrate 1 includes one first main surface 1a and the other first main surface 1b. The other first main surface 1b is a main surface opposite to one first main surface 1a. Each of these main surfaces is rectangular in shape, and thus main substrate 1 is a rectangular flat board member. Main substrate 1 is placed typically with each main surface thereof extending in the horizontal direction. Main substrate 1 is placed in such a manner that it extends longest in the depth direction in Fig. 1, has a width in the lateral direction in Fig. 1, and has a thickness in the vertical direction in Fig. 1. Accordingly, the depth direction, the lateral direction, and the vertical direction in Fig. 1 are respectively the extending direction, the width direction, and the thickness direction of main substrate 1 in three-dimensional printed wiring board 100.

Main substrate 1 has a slit 3 extending from one first main surface 1a to the other first main surface 1b. Slit 3 having a certain dimension is formed at the central portion with respect to the width direction and the extending direction when one first main surface 1a of main substrate 1 is seen in plan view. For example, in plan view, slit 3 is in the shape of a rectangle that extends longer in the extending direction of main substrate 1 than in the width direction of main substrate 1 intersecting the extending direction. Slit 3 in Fig. 1 is divided into a plurality of parts with respect to its extending direction (the direction along the extending direction of main substrate 1). That is, slit 3 is divided into a front-side slit 3a and a rear-side slit 3b spaced from each other with respect to the extending direction of main substrate 1. The definitions of the front side and the rear side as used herein will be described later.

Standing substrate 2 includes one second main surface 2a and the other second main surface 2b. The other second main surface 2b is a main surface opposite to one second main surface 2a. Each of these main surfaces generally has a rectangular shape except that it partially includes a region deviating from a rectangular shape. Therefore, standing substrate 2 is a generally rectangular flat board member.

As the region where the main surfaces of standing substrate 2 deviate from a rectangular shape, standing substrate 2 includes a support portion 4. Support portion 4 is a region inserted in slit 3 in main substrate 1, so as to form three-dimensional printed wiring board 100 comprising main substrate 1 and standing substrate 2, and so as to support the overall three-dimensional printed wiring board 100 from below to prevent it from toppling. That is, support portion 4 is a region disposed under main substrate 1 when inserted in slit 3 to form three-dimensional printed wiring board 100. By being inserted in slit 3, standing substrate 2 is joined to and integrated with main substrate 1 in such a manner that one second main surface 2a of standing substrate 2 intersects (e.g. orthogonally) one first main surface 1a of main substrate 1, for example. Since standing substrate 2 intersects, for example, orthogonally main substrate 1, the depth direction, the lateral direction, and the vertical direction in Fig. 1 are respectively the extending direction, the thickness direction, and the height direction of standing substrate 2 in three-dimensional printed wiring board 100.

Since support portion 4 is inserted in slit 3, support portion 4 is divided into a plurality of parts with respect to its extending direction (the direction along the extending direction of standing substrate 2), similarly to slit 3. That is, support portion 4 is divided into a front-side support portion 4a and a rear-side support portion 4b spaced from each other with respect to the extending direction of standing substrate 2. Thus, front-side support portion 4a is inserted in front-side slit 3a, and rear-side support portion 4b is inserted in rear-side slit 3b.

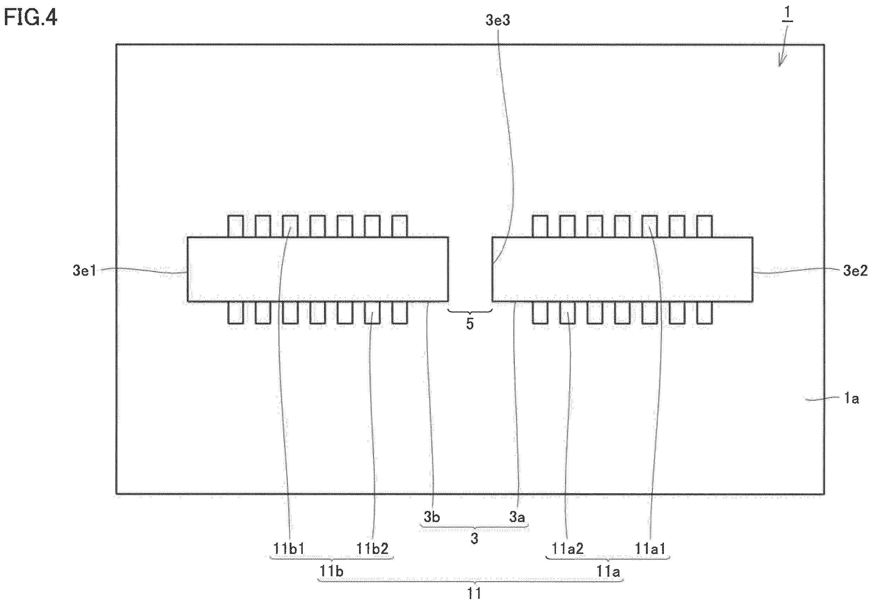

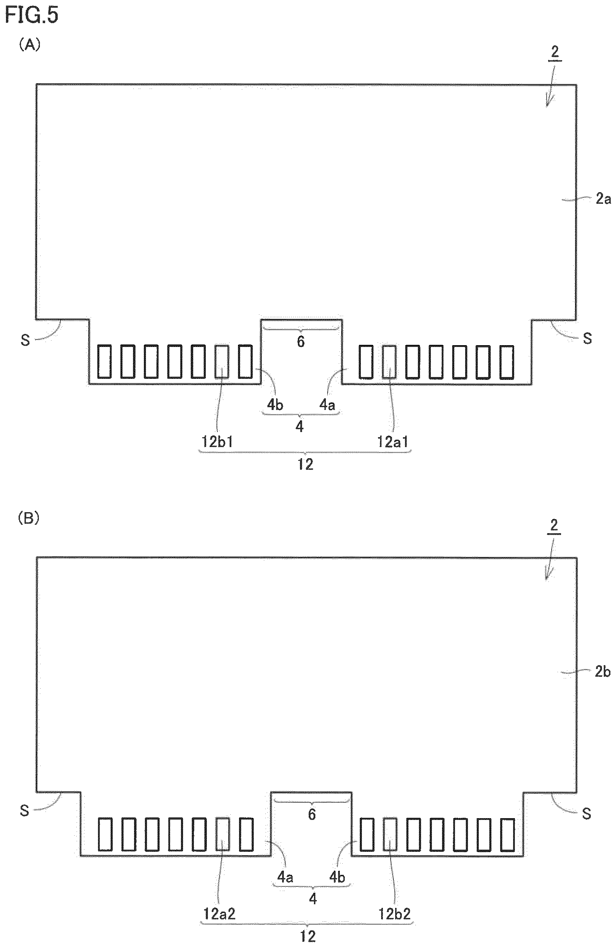

Thus, a plurality of (two in this case) slits 3 are spaced from each other with respect to the extending direction of main substrate 1, and the region between these slits 3 is formed as a slit divider 5 (see Fig. 4) in main substrate 1. Similarly, a plurality of (two in this case) support portions 4 are spaced from each other with respect to the extending direction of standing substrate 2, and the region between these support portions 4 is formed as a support-portion divider 6 (see Fig. 5) in standing substrate 2.

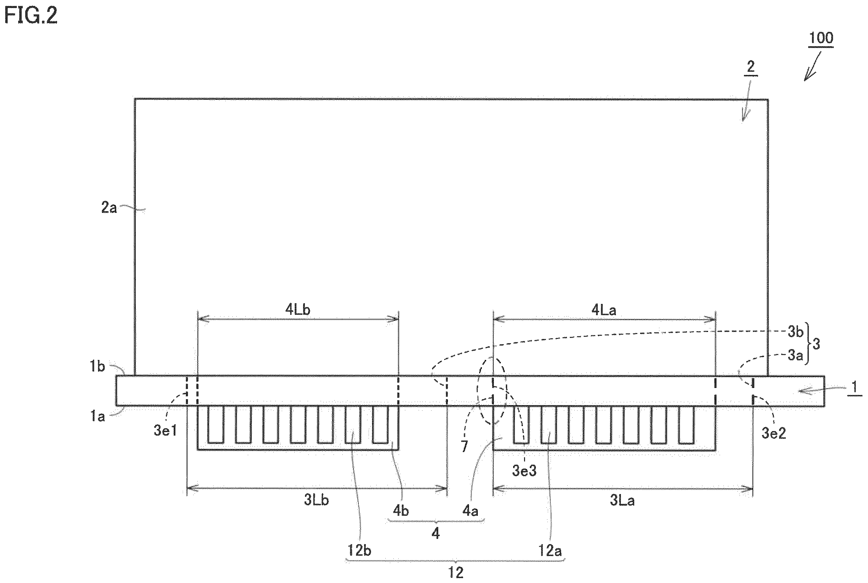

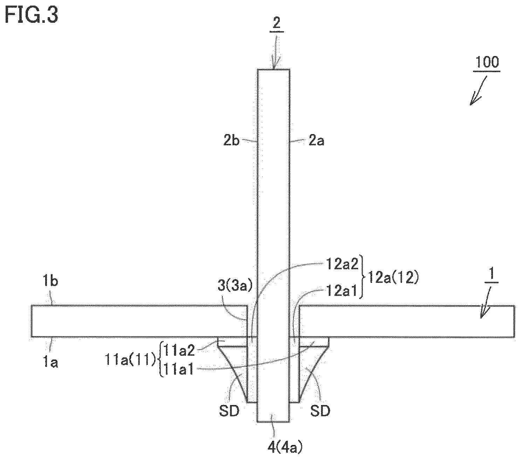

Fig. 2 is a diagram showing the configuration of three-dimensional printed wiring board 100 in the present embodiment as seen from the direction indicated by the arrow in Fig. 1. Fig. 3 is a diagram showing a cross section taken along line III-III in Fig. 1. Fig. 4 is a diagram showing one first main surface 1a of main substrate 1 in the present embodiment as seen in plan view. Fig. 5 is a diagram showing standing substrate 2 in the present embodiment as seen in plan view from the one second main surface 2a side and from the other second main surface 2b side. With reference to Fig. 2 to Fig. 5, in three-dimensional printed wiring board 100 in the present embodiment, main substrate electrodes 11 (first electrodes) are formed on one first main surface 1a of main substrate 1, in particular, on the region adjacent to slit 3; and standing substrate electrodes 12 (second electrodes) are formed on standing substrate 2, in particular, on support portion 4. Main substrate electrodes 11 on main substrate 1 and standing substrate electrodes 12 on standing substrate 2 are joined to each other with solder SD. Thus, main substrate 1 and standing substrate 2 are joined and integrally fixed to each other.

Specifically, main substrate electrodes 11 include front-side main substrate electrodes 11a formed particularly on the region adjacent to front-side slit 3a, and rear-side main substrate electrodes 11b formed particularly on the region adjacent to rear-side slit 3b. Standing substrate electrodes 12 include front-side standing substrate electrodes 12a formed particularly on front-side support portion 4a, and rear-side standing substrate electrodes 12b formed particularly on rear-side support portion 4b.

With reference particularly to Fig. 4, main substrate electrodes 11, both front-side main substrate electrodes 11a and rear-side main substrate electrodes 11b, are formed in a plurality of pairs on both of one side (the upper side in Fig. 4) and the other side (the lower side in Fig. 4), opposite to the one side, of slit 3 with respect to the width direction intersecting the extending direction of slit 3. In other words, the one side of slit 3 is the side where one second main surface 2a of standing substrate 2 inserted in slit 3 is located, and the other side of slit 3 is the side where the other second main surface 2b of standing substrate 2 inserted in slit 3 is located.

That is, front-side main substrate electrodes 11a include a one-side front-side main substrate electrode 11a1 formed on the one side, and an other-side front-side main substrate electrode 11a2 formed on the other side. Similarly, rear-side main substrate electrodes 11b include a one-side rear-side main substrate electrode 11b1 formed on the one side, and an other-side rear-side main substrate electrode 11b2 formed on the other side. A plurality of one-side front-side main substrate electrodes 11a1 and a plurality of other-side front-side main substrate electrodes 11a2 are arranged at intervals along the extending direction of slit 3 on one first main surface 1a of main substrate 1. Similarly, a plurality of one-side rear-side main substrate electrodes 11b1 and a plurality of other-side rear-side main substrate electrodes 11b2 are arranged at intervals along the extending direction of slit 3 on one first main surface 1a of main substrate 1. The number of one-side front-side main substrate electrodes 11a1 and the number of other-side front-side main substrate electrodes 11a2 are preferably the same, so that each electrode 11a1 and its corresponding electrode 11a2 form a pair. The number of one-side rear-side main substrate electrodes 11b1 and the number of other-side rear-side main substrate electrodes 11b2 are preferably the same, so that each electrode 11b1 and its corresponding electrode 11b2 form a pair.

With reference particularly to Fig. 5 (A), (B), standing substrate electrodes 12, both front-side standing substrate electrodes 12a and rear-side standing substrate electrodes 12b, are formed in a plurality of pairs on both of one second main surface 2a (see Fig. 5 (A)) and the other second main surface 2b (see Fig. 5 (B)) of standing substrate 2. That is, front-side standing substrate electrodes 12a include a one-side front-side standing substrate electrode 12a1 formed on one second main surface 2a, and an other-side front-side standing substrate electrode 12a2 formed on the other second main surface 2b. Similarly, rear-side standing substrate electrodes 12b include a one-side rear-side standing substrate electrode 12b1 formed on one second main surface 2a, and an other-side rear-side standing substrate electrode 12b2 formed on the other second main surface 2b. A plurality of one-side front-side standing substrate electrodes 12a1 and a plurality of other-side front-side standing substrate electrodes 12a2 are arranged at intervals along the extending direction of slit 3, with standing substrate 2 being inserted in slit 3. Similarly, a plurality of one-side rear-side standing substrate electrodes 12b1 and a plurality of other-side rear-side standing substrate electrodes 12b2 are arranged at intervals along the extending direction of slit 3, with standing substrate 2 being inserted in slit 3. The number of one-side front-side standing substrate electrodes 12a1 and the number of other-side front-side standing substrate electrodes 12a2 are preferably the same, so that each electrode 12a1 and its corresponding electrode 12a2 form a pair. The number of one-side rear-side standing substrate electrodes 12b1 and the number of other-side rear-side standing substrate electrodes 12b2 are preferably the same, so that each electrode 12b1 and its corresponding electrode 12b2 form a pair.

As shown in Fig. 3, one-side front-side main substrate electrode 11a1 as a main substrate electrode on one side on main substrate 1 and one-side front-side standing substrate electrode 12a1 as a standing substrate electrode on one second main surface 2a of standing substrate 2 formed as described above are electrically joined to each other with solder. Similarly, other-side front-side main substrate electrode 11a2 as a main substrate electrode on the other side on main substrate 1 and other-side front-side standing substrate electrode 12a2 as a standing substrate electrode on the other second main surface 2b of standing substrate 2 are electrically joined to each other with solder. Similarly, though not shown, one-side rear-side main substrate electrode 11b1 on one side on main substrate 1 and one-side rear-side standing substrate electrode 12b1 on one second main surface of standing substrate 2 are electrically joined to each other with solder. Further, other-side rear-side main substrate electrode 11b2 on the other side on main substrate 1 and other-side rear-side standing substrate electrode 12b2 on the other second main surface of standing substrate 2 are electrically joined to each other with solder.

Thus, main substrate electrodes 11a1, 11b1 on one side and standing substrate electrodes 12a1, 12b1 on one second main surface 2a are electrically joined to each other with solder so as to have different electric potentials. Main substrate electrodes 11a2, 11b2 on the other side and standing substrate electrodes 12a2, 12b2 on the other second main surface are electrically joined to each other with solder so as to have different electric potentials. Thus, an electric circuit is formed connecting the electrodes on one second main surface 2a and the electrodes on the other second main surface 2b. As shown in Fig. 3, in three-dimensional printed wiring board 100, one first main surface 1a preferably faces downward, so that a region below main substrate 1 can be joined with solder SD.

In three-dimensional printed wiring board 100 in the present embodiment, slit 3, in which support portion 4 is inserted, is greater than support portion 4 in dimension, as seen from above in Fig. 1, for example. That is, with reference to Fig. 2, for example, dimension 3La of front-side slit 3a with respect to the extending direction of slit 3 is greater than dimension 4La of front-side support portion 4a with respect to the extending direction. Also, dimension 3Lb of rear-side slit 3b with respect to the extending direction is greater than dimension 4Lb of rear-side support portion 4b with respect to the extending direction. Therefore, with respect to the extending direction, there is a clearance between the end portion of front-side slit 3a (as the inner wall surface of front-side slit 3a) and the end portion of front-side support portion 4a.

Also, with reference to Fig. 3, the width of front-side slit 3a with respect to the width direction of slit 3 (the dimension in the lateral direction in Fig. 3) is greater than the thickness of standing substrate 2. Thus, there is a clearance between the inner wall surface of front-side slit 3a and one second main surface 2a (the other second main surface 2b).

As shown in Fig. 2, three-dimensional printed wiring board 100 in the present embodiment has a restraint point 7, particularly in slit 3, at which slit 3 and standing substrate 2 are in contact with, restrained by, and fixed to each other. This restraint point 7 is formed at an inner end portion 3e3, as a position other than one end portion 3e1 or the other end portion 3e2 opposite to one end portion 3e1 with respect to the extending direction of slit 3 of the entire row of a plurality of slits 3 arranged in the extending direction of slit 3. In other words, restraint point 7 is at inner end portion 3e3 of any one of a pair of adjacent slits 3 in the row of a plurality of slits 3 arranged in the extending direction of slit 3. At the portion other than restraint point 7, slit 3 and standing substrate 2 are not in contact with each other, with a clearance lying between them. That is, one end portion 3e1 of slit 3 is not in contact with support substrate 4, and the other end portion 3e2 is not in contact with support substrate 4.

Restraint point 7 between slit 3 and standing substrate 2 is more preferably at the central position with respect to the lateral direction in Fig. 2, i.e., the direction in which a plurality of standing substrate electrodes 12 are arranged. Restraint point 7 is formed preferably in such a manner that the distance from the central position of main substrate 1 to restraint point 7 with respect to the direction in which standing substrate electrodes 12 are arranged is within 10% of the dimension of main substrate 1 with respect to the said direction.

That is, the row of a plurality of arranged slits 3 in Fig. 2 refers to the row of two slits 3 arranged in the lateral direction in Fig. 2. One end portion 3e1 with respect to the extending direction in the entire row refers to the end portion as the position at the one extreme end (the left end in Fig. 2) of slit 3 in the entire row of two arranged slits 3. The other end portion 3e2 refers to the end portion as the position at the other extreme end (the right end in Fig. 2) of slit 3 in the entire row of two arranged slits 3. Inner end portion 3e3 refers to an end portion other than one end portion 3e1 and the other end portion 3e2, among the end portions with respect to the extending direction of a plurality of slits 3. That is, inner end portion 3e3 refers to any one end portion of any one slit 3 that is located between one end portion 3e1 and the other end portion 3e2.

In Fig. 2, one end portion 3e1 refers to the left end portion of rear-side slit 3b in Fig. 2, the other end portion 3e2 refers to the right end portion of front-side slit 3a in Fig. 2, and inner end portion 3e3 refers to the left end portion of front-side slit 3a in Fig. 2. Similarly, in Fig. 2, a row of support portions 4 is formed by a plurality of (two) support portions 4 arranged in the lateral direction in Fig. 2.

In Fig. 2, front-side slit 3a and front-side support portion 4a are in contact with each other with respect to the extending direction at the end portion of front-side slit 3a at which front-side slit 3a is closest to rear-side slit 3b. Thus, rearmost inner end portion 3e3 of front-side slit 3a forms restraint point 7.

As shown in Fig. 2, each of a plurality of support portions 4 is inserted in a corresponding one of a plurality of slits 3. That is, front-side support portion 4a is inserted in front-side slit 3a, and rear-side support portion 4b is inserted in rear-side slit 3b. The dimension difference with respect to the extending direction between rear-side slit 3b as a first slit on the one end portion 3e1 side among a plurality of slits 3, and rear-side support portion 4b as a first support portion on the one end portion 3e1 side among a plurality of support portions 4 and inserted in the first slit is 3Lb - 4Lb. The dimension difference with respect to the extending direction between front-side slit 3a as a second slit other than the first slit among a plurality of slits 3, and front-side support portion 4a as a second support portion other than the first support portion among a plurality of support portions 4 is 3La - 4La. In the present embodiment, the value of 3Lb - 4Lb is different from the value of 3La - 4La. Here, 3Lb - 4Lb is larger than 3La - 4La in particular.

Next, a method for manufacturing a three-dimensional printed wiring board in the present embodiment is described with reference to Fig. 4 to Fig. 7.

Referring back to Fig. 4, main substrate 1 is prepared. Main substrate 1 may be made of, for example, a commonly known glass epoxy base material. Main substrate 1, however, is not limited to this, but may be made of a material selected from the group consisting of glass cloth, nonwoven glass fabric, and paper base material, impregnated with a material selected from the group consisting of epoxy resin, polyimide resin, and phenol resin, for example. Alternatively, main substrate 1 may be made of a base material composed of ceramics.

The above-described base material is partially removed by a removal process on main substrate 1 using commonly known photolithography (exposure development and etching) or using a laser beam machine, thereby forming slit 3 extending from one first main surface 1a to the other first main surface 1b. Slit 3 is divided into a plurality of parts with respect to its extending direction. Here, slit 3 is divided into two parts, front-side slit 3a and rear-side slit 3b, with slit divider 5 lying therebetween.

On one first main surface 1a of main substrate 1, one-side front-side main substrate electrode 11a1, other-side front-side main substrate electrode 11a2, one-side rear-side main substrate electrode 11b1, and other-side rear-side main substrate electrode 11b2 are formed as a plurality of main substrate electrodes 11. Further, as described above, two arranged slits 3 have one end portion 3e1, the other end portion 3e2, and inner end portion 3e3 with respect to the extending direction of the entire row (the lateral direction in Fig. 4).

Referring back to Fig. 5 (A), (B), standing substrate 2 which can be joined to main substrate 1 is prepared. Standing substrate 2 is preferably made of the same base material as that of main substrate 1.

Support portion 4, a lower region of standing substrate 2, is divided into a plurality of parts with respect to the lateral direction in Fig. 5 (the extending direction of slit 3 in which support portion 4 is inserted). Here, support portion 4 is divided into two parts, front-side support portion 4a and rear-side support portion 4b, with support-portion divider 6 lying therebetween.

The region where support portion 4 is formed is the region slightly on the inner side relative to the end portions with respect to the extending direction of standing substrate 2 (the lateral direction in Fig. 5). Steps S are formed between the end portions in the extending direction of standing substrate 2 and the outermost surfaces of support portion 4 closest to the end portions. These steps S serve as a stopper for setting standing substrate 2 such that standing substrate 2 is in contact with the main surface of main substrate 1 when standing substrate 2 is inserted in slit 3.

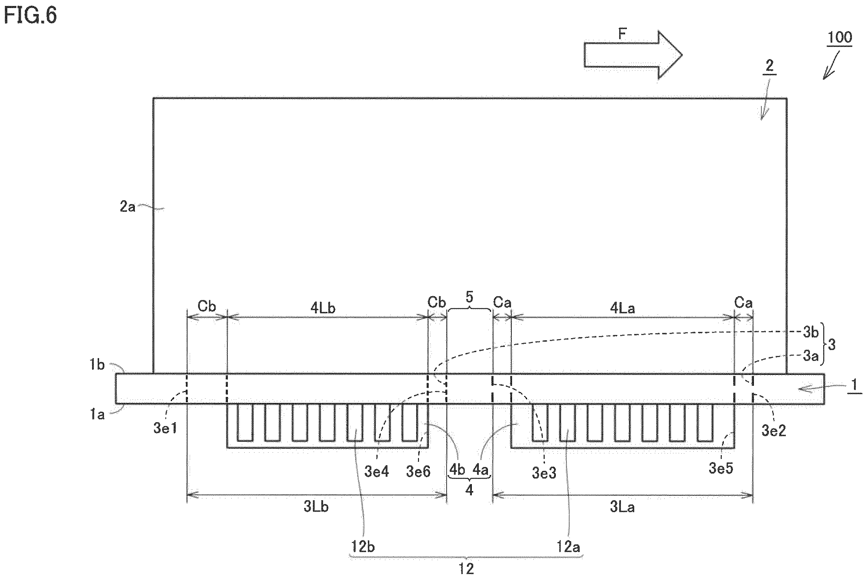

With reference to Fig. 6, standing substrate 2 is inserted in slit 3 in main substrate 1. At this time, where the other first main surface 1b of main substrate 1 is on the upper side and one first main surface 1a of main substrate 1 is on the lower side, support portion 4 is inserted through slit 3 from the other first main surface 1b side (i.e., the upper side). Thus, one second main surface 2a of standing substrate 2 intersects (e.g. orthogonally) one first main surface 1a of main substrate 1, for example. A plurality of standing substrate electrodes 12 formed on support portion 4 extend through slit 3 to be exposed at the region below one first main surface 1a of main substrate 1.

While standing substrate 2 is inserted as described above, flow soldering is performed on the set main substrate 1 and standing substrate 2. In this flow soldering, first, one first main surface 1a and the region of support portion 4 below one first main surface 1a, in particular, of main substrate 1 and standing substrate 2 are immersed in molten solder in a bath (not shown) to be wet with the molten solder. As the molten solder, a commonly used alloy material, e.g. Sn-3.0Ag-0.5Cu may be used. However, the molten solder is not limited to this, but may be a solder selected from the group consisting of Sn-Cu based solder, Sn-Bi based solder, Sn-In based solder, Sn-Sb based solder, and Sn-Pb based solder. Main substrate 1 and standing substrate 2, while being immersed in the molten solder (in particular, jet stream solder jetting upward), flow in the direction indicated by arrow F in Fig. 6.

Thus, as shown in Fig. 3 for example, a plurality of main substrate electrodes 11 (11a) formed along the extending direction of slit 3 on one first main surface 2a of main substrate 1 are joined, with solder SD, to a plurality of standing substrate electrodes 12 (12a) formed along the extending direction of slit 3 on one second main surface 2a and the other second main surface 2b of standing substrate 2. Although not shown, rear-side main substrate electrodes 11b are similarly joined to rear-side standing substrate electrodes 12b with solder SD.

At this time, in the solder bath, main substrate 1 and standing substrate 2 are placed in such a manner that their extending direction (i.e., the extending direction of slit 3) is along the direction in which main substrate 1 and standing substrate 2 are transferred (i.e., the direction indicated by arrow F). Both substrates are transferred while keeping this position. That is, front-side slit 3a flows in front of rear-side slit 3b in the flow path in the bath, and thus the soldering of front-side slit 3a progresses ahead of rear-side slit 3b. Similarly, front-side support portion 4a flows in front of rear-side support portion 4b in the flow path, and thus the soldering of front-side support portion 4a progresses ahead of rear-side support portion 4b. This is why the divided slits and support portions are indicated by the terms "front side" or "rear side".

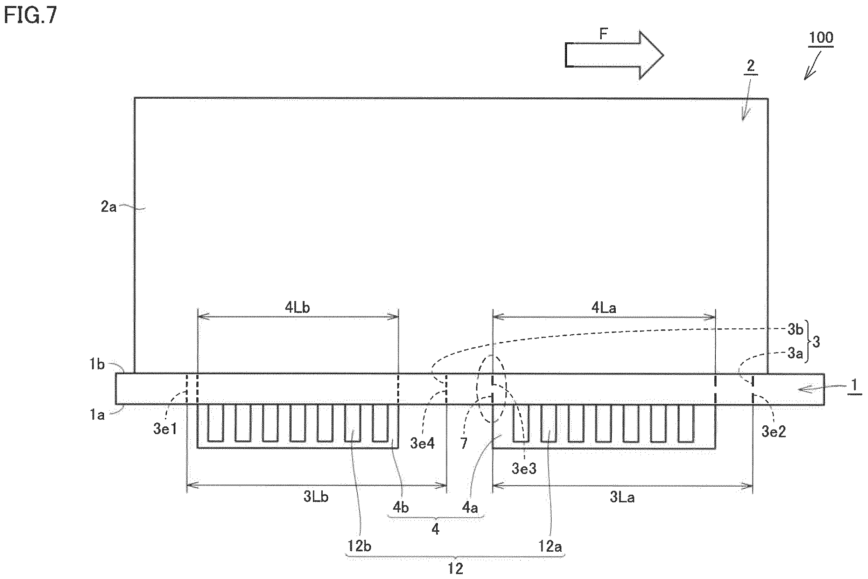

Fig. 6 shows the state, as seen in the same direction as Fig. 2, in which support portion 4 in standing substrate 2 is inserted in slit 3 and starts to be transferred in the direction indicated by arrow F in the flow soldering. On the other hand, Fig. 7 shows a state, as seen in the same direction as Fig. 2, in which main substrate 1 and standing substrate 2 have been transferred by the flow soldering, which is an embodiment of a finished product of three-dimensional printed wiring board 100. As shown in Fig. 6, when support portion 4 is initially inserted in slit 3, front-side support portion 4a is within the region between the other end portion 3e2 and inner end portion 3e3, where front-side support portion 4a is not in contact with any of the other end portion 3e2 and opposite inner end portion 3e3 of front-side slit 3a with respect to the extending direction of each substrate. This is because dimension 4La of front-side support portion 4a is greater than dimension 3La of front-side slit 3a in the extending direction, and there is a clearance Ca as the difference between them.

Similarly, when support portion 4 is initially inserted in slit 3, rear-side support portion 4b is within the region between one end portion 3e1 and inner end portion 3e4, where rear-side support portion 4b is not in contact with any of one end portion 3e1 and opposite inner end portion 3e4 of rear-side slit 3b with respect to the extending direction of each substrate. This is because dimension 4Lb of rear-side support portion 4b is greater than dimension 3Lb of rear-side slit 3b in the extending direction, and there is a clearance Cb as the difference between them. Here, inner end portion 3e4 refers to the frontmost end portion of rear-side slit 3b with respect to the substrate transfer direction.

The dimension difference in the extending direction between rear-side slit 3b as a first slit at the rearmost portion in the transfer direction of main substrate 1 in the flow soldering among a plurality of slits 3, and rear-side support portion 4b as a first support portion at the rearmost portion among a plurality of support portions 4 and inserted in the first slit is clearance Cb in Fig. 6. The dimension difference in the extending direction between front-side slit 3a as a second slit other than the first slit among a plurality of slits 3, and front-side support portion 4a as a second support portion other than the first support portion among a plurality of support portions 4 is clearance Ca in Fig. 6. In the present embodiment, the dimension of each portion is adjusted so that clearance Cb is greater than clearance Ca. In Fig. 6, two clearances Ca are formed on the right and left sides of support portion 4, and two clearances Cb are formed on the right and left sides of support portion 4. Here, the sum of the dimensions of two clearances Ca is considered as clearance Ca, and the sum of the dimensions of two clearances Cb is considered as clearance Cb.

As shown in Fig. 6, in the present embodiment, dimension 3La of front-side slit 3a and dimension 3Lb of rear-side slit 3b are (substantially) equal with respect to the extending direction, and dimension 4La of front-side support portion 4a is greater than dimension 4Lb of rear-side support portion 4b with respect to the extending direction. As a result, in the present embodiment, clearance Cb is greater than clearance Ca. Further, in Fig. 6, the distance between the frontmost support end portion 3e5 with respect to the extending direction of front-side support portion 4a, and the frontmost support end portion 3e6 with respect to the extending direction of rear-side support portion 4b is preferably equal to the distance between the other end portion 3e2 with respect to the extending direction of front-side slit 3a and frontmost inner end portion 3e4 with respect to the extending direction of rear-side slit 3b.

With reference to Fig. 7, however, as the transfer process in the solder bath progresses, standing substrate 2 flows rearward relative to main substrate 1 with respect to the direction of arrow F in which each substrate flows. This is because standing substrate 2, which extends along the vertical direction, receives greater resistance from the jet stream solder in the solder bath in the direction opposite to the substrate flowing direction than main substrate 1, which is disposed along the horizontal direction. As a result, restraint point 7 is formed at which inner end portion 3e3 is in contact with the rearmost portion of front-side support portion 4a (support end portion 3e5 in Fig. 6) and at which slit 3 in main substrate 1 and standing substrate 2 are in contact with, restrained by, and fixed to each other. This restraint point 7 is formed at a position other than one end portion 3e1 and the other end portion 3e2 opposite to one end portion 3e1 with respect to the extending direction of the entire row of a plurality of slits 3 arranged in the extending direction. In other words, restraint point 7 is formed at inner end portion 3e3 of any one of a pair of adjacent slits 3 in the row of a plurality of slits 3 arranged in the extending direction, so that slit 3 and standing substrate 2 are in contact with each other at restraint point 7.

Thus, at restraint point 7 between one end portion 3e1 and the other end portion 3e2, main substrate 1 and standing substrate 2 are in contact with and integrally fixed to each other, thus forming three-dimensional printed wiring board 100. With restraint point 7 formed as described above, main substrate electrodes 11 and standing substrate electrodes 12 are joined to each other with molten solder as shown in Fig. 3.

Note that, as described above, support end portion 3e5, 3e6 may be considered as the one extreme end portion (the left end in Fig. 6), or may be considered as the other extreme end portion (the right end in Fig. 6).

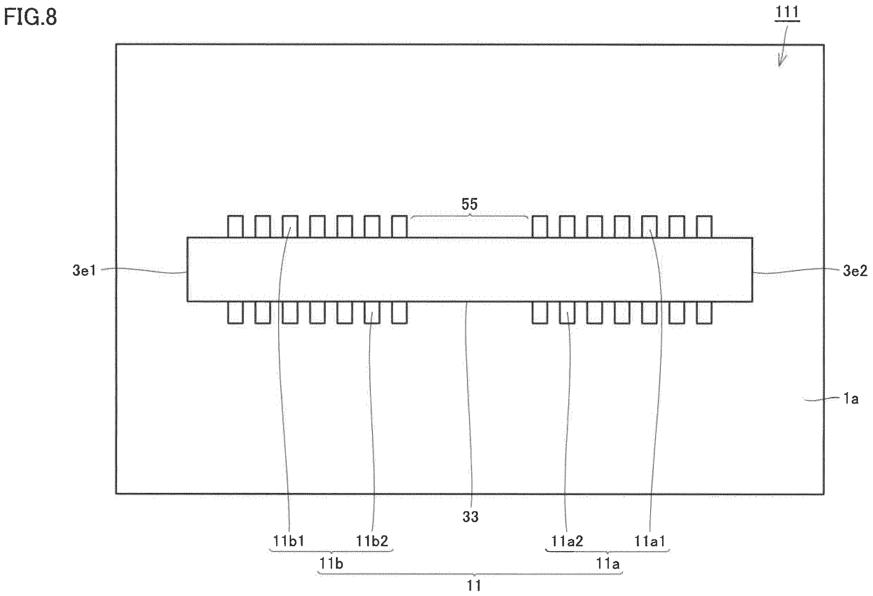

Next, the advantageous effects of the present embodiment are described with reference to a comparative example in Fig. 8 to Fig. 10, and Fig. 11 to Fig. 12.

Fig. 8 is a diagram showing one first main surface 1a of a main substrate 111 in a comparative example in plan view. With reference to Fig. 8, main substrate 111 constituting a three-dimensional printed wiring board in the comparative example is basically the same in configuration as main substrate 1 in the present embodiment. Thus, identical components are identically denoted, and the explanation thereof is not repeated. However, in main substrate 111 in the comparative example, a slit 33 is not divided into a plurality of parts, but is continuous with respect to its extending direction. However, a divider counterpart region 55, which corresponds to slit divider 5 between a plurality of slits 3 in main substrate 1 in the present embodiment, does not include main substrate electrode 11. Main substrate electrodes 11 are formed in the region adjacent to the region other than divider counterpart region 55 with respect to the direction in which slit 33 extends, in the same manner as main substrate electrodes 11 in the present embodiment disposed adjacent to divided slits 3.

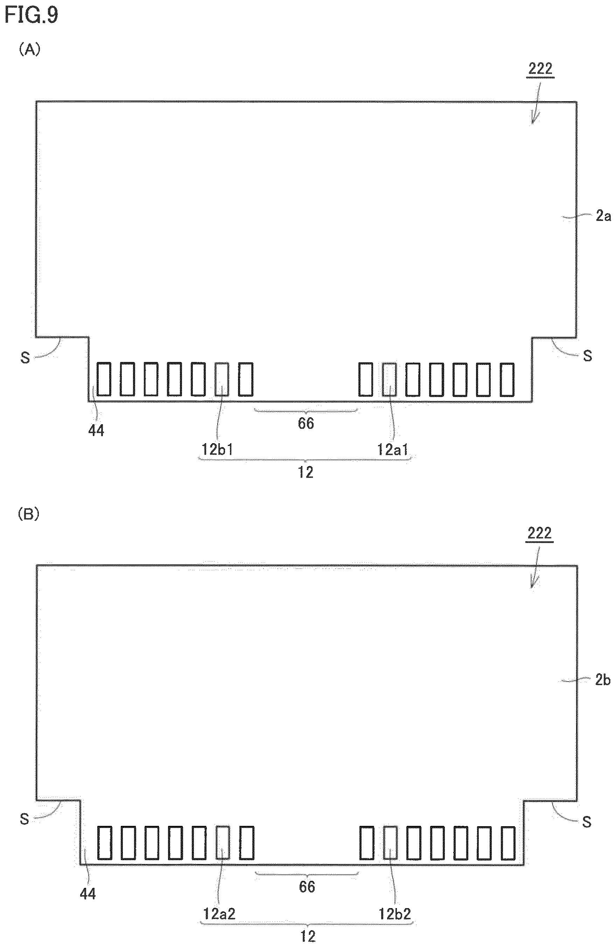

Fig. 9 is a diagram showing a standing substrate 222 in the comparative example as seen in plan view from each of the one second main surface 2a side and the other second main surface 2b side. With reference to Fig. 9, standing substrate 222 constituting the three-dimensional printed wiring board in the comparative example is basically the same in configuration as standing substrate 2 in the present embodiment. Thus, identical components are identically denoted, and the explanation thereof is not repeated. However, in standing substrate 222 in the comparative example, a support portion 44 is not divided into a plurality of parts, but is continuous with respect to its extending direction. However, a divider counterpart region 66, which corresponds to support-portion divider 6 between a plurality of support portions 4 in standing substrate 2 in the present embodiment, does not include standing substrate electrode 12. Standing substrate electrodes 12 are formed in the region adjacent to the region other than divider counterpart region 66 with respect to the direction in which support portion 44 extends, in the same manner as standing substrate electrodes 12 in the present embodiment disposed adjacent to divided support portions 4.

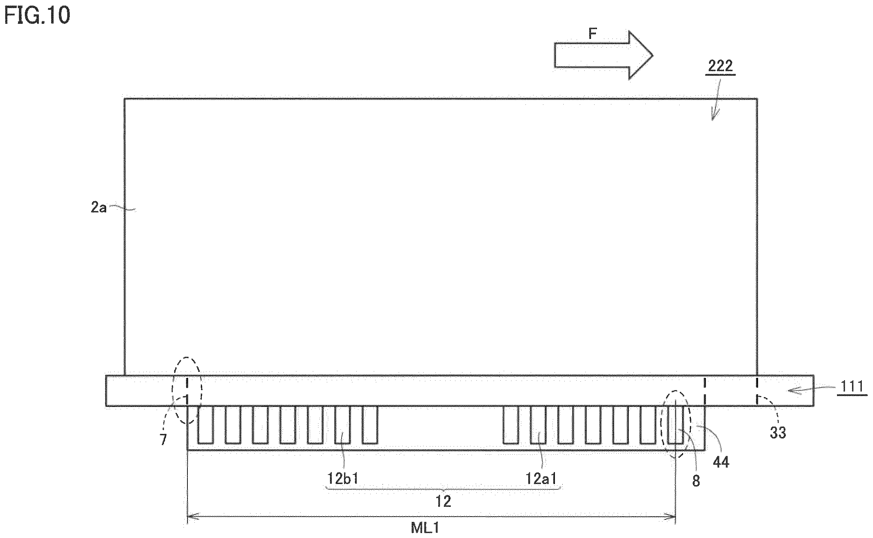

Fig. 10 shows flow soldering in a solder bath for a combination of the two substrates in the comparative example, similarly to the process in Fig. 6 and Fig. 7 in the present embodiment. With reference to Fig. 10, in the comparative example, the flow soldering causes standing substrate 222 to flow rearward relative to main substrate 111 with respect to the substrate flow direction indicated by arrow F, as in the present embodiment. The rearmost portion of slit 33 and the rearmost portion of support portion 44 with respect to the extending direction are in contact with each other, and slit 3 and standing substrate 2 are in contact with and restrained by each other. Thus, restraint point 7 is formed at which main substrate 1 and standing substrate 2 are integrally fixed to each other.

Suppose that main substrate 111 and standing substrate 222 are joined by soldering, with such a restraint point 7 being formed, and that driving and stopping operations are repeated using a three-dimensional printed wiring board as a product. Fig. 10 shows occurrence of thermal distortion when driving and stopping operations are repeated using the three-dimensional printed wiring board formed by the comparative example as a product. With reference to Fig. 10, in the comparative example, restraint point 7 between slit 3 and support portion 4 is formed at the rearmost portion of slit 3 and support portion 4. This is because standing substrate 222 flows rearward relative to main substrate 111 at the time of flow soldering as described above. In this case, when the three-dimensional printed wiring board is used, the electronic components and circuit patterns included therein repeat heat generation and cooling. That is, under the use environment, main substrate 111 and standing substrate 222 constituting the three-dimensional printed wiring board repeat thermal expansion and thermal contraction caused by temperature cycle of heat generation and cooling.

In particular, if main substrate 111 and standing substrate 222 are made of different base materials, the difference in coefficient of linear expansion between them causes a difference in the amount of thermal expansion and contraction between main substrate 111 and standing substrate 222. If main substrate 111 and standing substrate 222 are made of the same type of base material, on the other hand, a slight difference in coefficient of linear expansion between them causes a slight difference in the amount of thermal expansion and contraction between main substrate 111 and standing substrate 222. This is due to, for example, variations in remaining copper rate and variations in base material among lots at the time of manufacturing the three-dimensional printed wiring board.

As described above, in the three-dimensional printed wiring board, the main substrate and the standing substrate are in contact with and fixed to each other at restraint point 7. Further, the thermal distortion of the joint at which main substrate electrode 11 and standing substrate electrode 12 are joined with solder increases in proportion to the distance from restraint point 7. Thus, the temperature cycle under the use environment produces the greatest thermal distortion at a maximum distortion soldering portion 8 of main substrate electrode 11 and standing substrate electrode 12, which is remotest from restraint point 7 with respect to the extending direction of slit 3. That is, maximum distortion soldering portion 8 is the portion most likely to break during use of the three-dimensional printed wiring board.

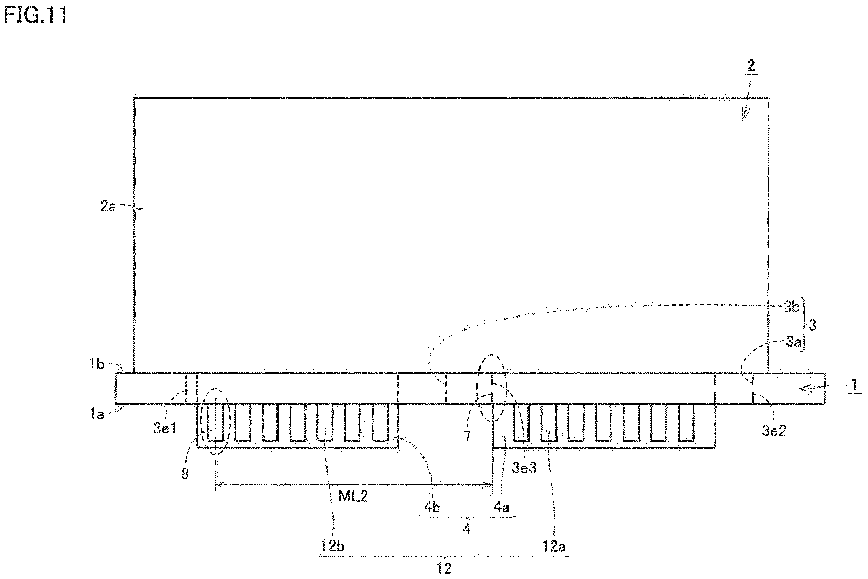

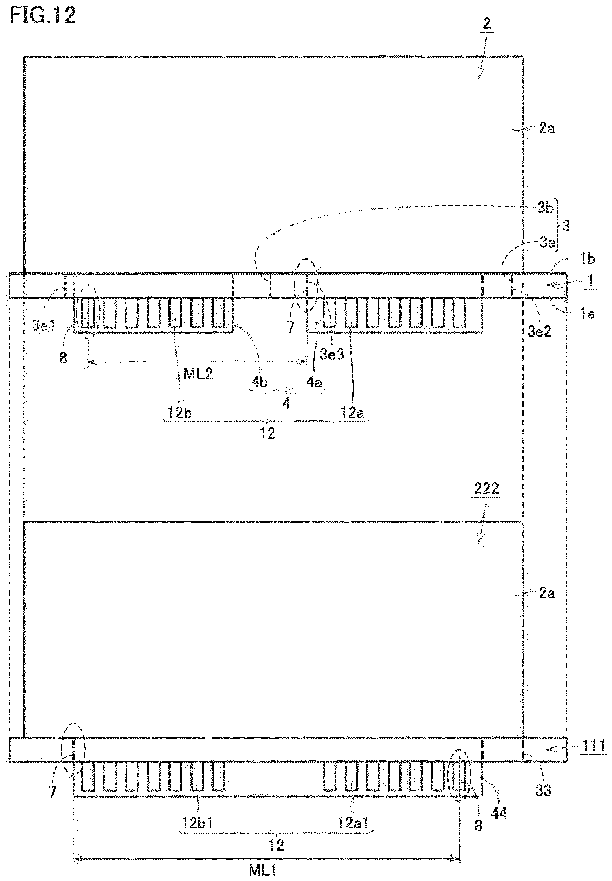

Fig. 11 shows the positions of restraint point 7 and maximum distortion soldering portion 8 and the distance between restraint point 7 and maximum distortion soldering portion 8 after the flow soldering in Fig. 6 and Fig. 7 in the present embodiment. Fig. 12 shows vertically arranged Fig. 10 and Fig. 11 for easy comparison between the comparative example and the present embodiment, in terms of the distance between restraint point 7 and maximum distortion soldering portion 8.

With reference to Fig. 10 to Fig. 12, in the comparative example, restraint point 7 is located at the rearmost portion of slit 3 with respect to the substrate transfer direction indicated by arrow F, while soldering portion 8 with the greatest thermal distortion is located at standing substrate electrode 12 at the forefront portion of slit 3 with respect to the transfer direction. The distance between restraint point 7 and maximum distortion soldering portion 8 with respect to the extending direction of slit 3 is ML1, which is substantially equal to the extending length of slit 3 across a large part of main substrate 111 in its extending direction.

In the present embodiment, on the other hand, restraint point 7 is located at the rearmost portion of front-side slit 3a with respect to the substrate transfer direction indicated by arrow F, while maximum distortion soldering portion 8, which is a soldering portion remotest from restraint point 7, is located at standing substrate electrode 12 at the rearmost portion of rear-side support portion 4b. The distance between restraint point 7 and maximum distortion soldering portion 8 with respect to the extending direction of slit 3 is ML2. Distance ML2 is much shorter than distance ML1 in the comparative example where restraint point 7 is located at one end portion of the entire slit 3 with respect to the extending direction.

The comparative example and the present embodiment are the same in the dimension and placement of the main substrate, the standing substrate, slit 3, main substrate electrodes 11, and standing substrate electrodes 12 with respect to the extending direction. However, in the present embodiment, each of slit 3 and support portion 4 is divided into a plurality of parts with respect to the extending direction. Thus, restraint point 7 at which slit 3 in main substrate 1 and support portion 4 in standing substrate 2 are in contact with and fixed to each other can be located at inner end portion 3e3 other than one end portion 3e1 and the other end portion 3e2 of the entire rows of slits 3 and support portions 4. Accordingly, as shown in Fig. 12, distance ML2 between restraint point 7 and maximum distortion soldering portion 8 with respect to the extending direction can be made shorter than distance ML1 in the comparative example. This can reduce the thermal distortion caused by temperature cycle under the use environment and prolong the life of the solder joint portions between main substrate electrodes 11 and standing substrate electrodes 12.

As described above, the dimension difference Cb = 3Lb - 4Lb in the extending direction between rear-side slit 3b and rear-side support portion 4b on the one end portion 3e1 side (the rearmost portion in the flow soldering) is different from dimension difference Ca = 3La - 4La in the extending direction between the other front-side slit 3a and the other front-side support portion 4a. Here, dimension difference Cb = 3Lb - 4Lb is greater than dimension difference Ca = 3La - 4La, in particular. By controlling the dimension of each portion in the extending direction so as to satisfy the above condition, standing substrate 2 moves rearward relative to main substrate 1 with respect to the substrate flow direction at the time of flow soldering, thus allowing easy formation of restraint point 7 at inner end portion 3e3 as described above.

In Fig. 6, restraint point 7 is formed reliably at inner end portion 3e3 if the distance between frontmost support end portion 3e5 of front-side support portion 4a and frontmost support end portion 3e6 of rear-side support portion 4b is equal to the distance between the frontmost other end portion 3e2 of front-side slit 3a and frontmost inner end portion 3e4 of rear-side slit 3b. This is because, in this case, the distance between rearmost support end portion 3e5 of front-side support portion 4a and rearmost support end portion 3e6 of rear-side support portion 4b is shorter than the distance between rearmost inner end portion 3e3 of front-side slit 3a and rearmost one end portion 3e1 of rear-side slit 3b, thus making it impossible for rearmost support end portion 3e6 of rear-side support portion 4b to be in contact with one end portion 3e1.

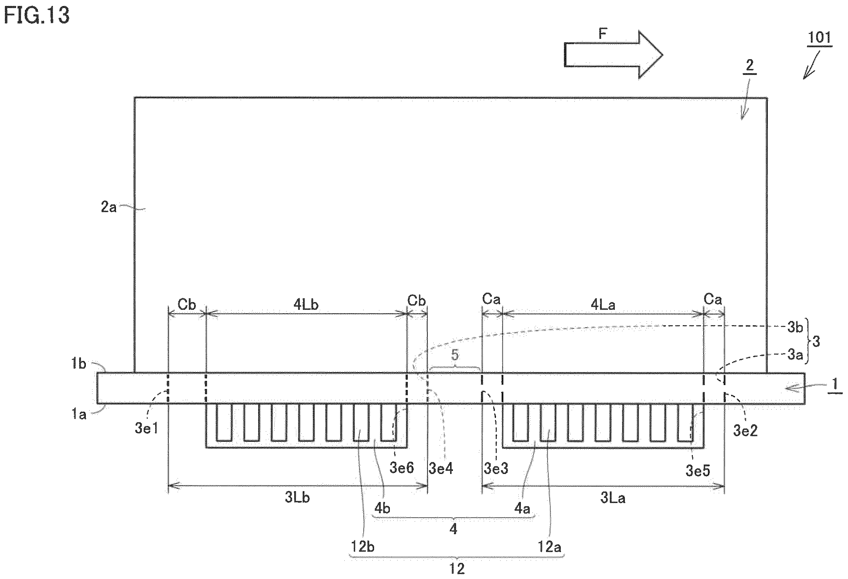

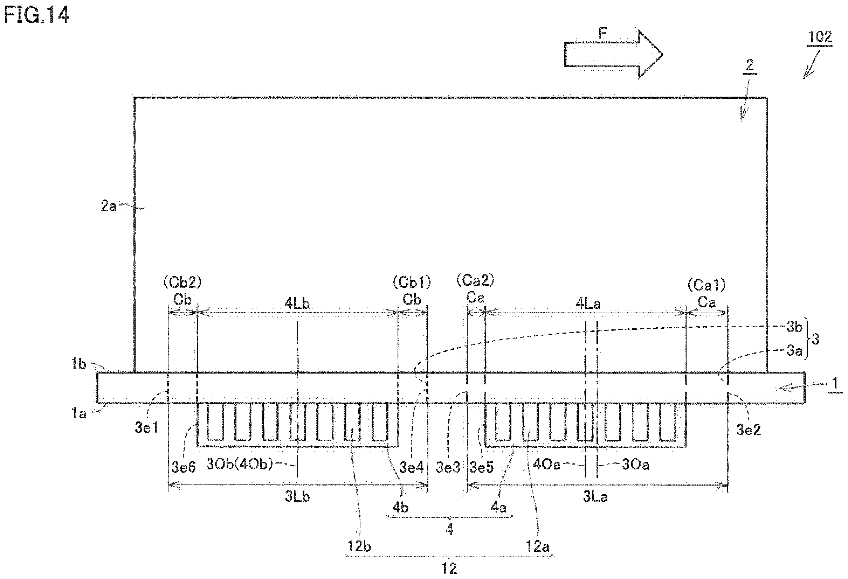

Next, a variation of the present embodiment is described with reference to Fig. 13 and Fig. 14.

Fig. 13 shows a mode of flow soldering in a first variation of the present embodiment, similarly to Fig. 6. With reference to Fig. 13, a three-dimensional printed wiring board 101 in the first variation of the present embodiment is basically the same in configuration as three-dimensional printed wiring board 100 in the present embodiment described above. Thus, identical components are identically denoted, and the explanation thereof is not repeated. In three-dimensional printed wiring board 101, however, dimension 4La of front-side support portion 4a is (substantially) equal to dimension 4Lb of rear-side support portion 4b with respect to the extending direction, and dimension 3Lb of rear-side slit 3b is greater than dimension 3La of front-side slit 3a with respect to the extending direction. In this respect, Fig. 13 is different from the configuration of three-dimensional printed wiring board 100 in Fig. 6 where dimension 3La of front-side slit 3a and dimension 3Lb of rear-side slit 3b are (substantially) equal with respect to the extending direction, and where dimension 4La of front-side support portion 4a is greater than dimension 4Lb of rear-side support portion 4b with respect to the extending direction. In Fig. 13, similarly to Fig. 6, the distance between frontmost support end portion 3e5 of front-side support portion 4a and frontmost support end portion 3e6 of rear-side support portion 4b is preferably equal to the distance between the frontmost other end portion 3e2 of front-side slit 3a and frontmost inner end portion 3e4 of rear-side slit 3b.

As a result, in three-dimensional printed wiring board 101, clearance Cb is greater than clearance Ca, as in three-dimensional printed wiring board 100. With such a configuration, as in three-dimensional printed wiring board 100, standing substrate 2 moves rearward relative to main substrate 1 with respect to the substrate flow direction at the time of flow soldering, thus allowing easy formation of restraint point 7 at inner end portion 3e3 as described above.

Fig. 14 shows a mode of flow soldering in a second variation of the present embodiment, similarly to Fig. 6. With reference to Fig. 14, a three-dimensional printed wiring board 102 in the second variation of the present embodiment is basically the same in configuration as three-dimensional printed wiring board 100 in the present embodiment described above. Thus, identical components are identically denoted, and the explanation thereof is not repeated.

In three-dimensional printed wiring board 102, dimension 3La of front-side slit 3a is (substantially) equal to dimension 3Lb of rear-side slit 3b with respect to the extending direction, and dimension 4La of front-side support portion 4a is (substantially) equal to dimension 4Lb of rear-side support portion 4b with respect to the extending direction. Accordingly, the values of clearance Ca and clearance Cb are (substantially) equal. Front-side support portion 4a is formed in such a manner that, when center line 3Ob of rear-side slit 3b and center line 4Ob of rear-side support portion 4b with respect to the extending direction of slit 3 is aligned, center line 4Oa of front-side support portion 4a is displaced rearward in the transfer direction indicated by arrow F, relative to center line 3Oa of front-side slit 3a with respect to the extending direction of slit 3. Divided slits 3 and support portions 4 are designed with such a positional relationship.

Here, as shown in Fig. 14, total clearance Ca (the dimension difference between front-side slit 3a and front-side support portion 4a in the extending direction) is considered as the sum of a front-side clearance Ca1 of front-side support portion 4a and a rear-side clearance Ca2 of front-side support portion 4a. Similarly, total clearance Cb (the dimension difference between rear-side slit 3b and rear-side support portion 4b in the extending direction) is considered as the sum of a front-side clearance Cb1 of rear-side support portion 4b and a rear-side clearance Cb2 of rear-side support portion 4b. The above-described design makes the value of Ca2 smaller than the value of Cb2, though the values of Ca and Cb being equal. As a result, restraint point 7 can be formed reliably at inner end portion 3e3. This is because, in this case, the distance between rearmost support end portion 3e5 of front-side support portion 4a and rearmost support end portion 3e6 of rear-side support portion 4b is shorter than the distance between rearmost inner end portion 3e3 of front-side slit 3a and rearmost one end portion 3e1 of rear-side slit 3b, thus making it impossible for rearmost support end portion 3e6 of rear-side support portion 4b to be in contact with one end portion 3e1.

As described above, clearance Cb greater than clearance Ca is advantageous in forming restraint point 7 at inner end portion 3e3 in the flow soldering. In terms of more reliable formation of restraint point 7 at inner end portion 3e3, however, it is more preferable that the distance between support end portion 3e6 of rear-side support portion 4b and support end portion 3e5 of front-side support portion 4a be shorter than the distance between one end portion 3e1 of rear-side slit 3b and inner end portion 3e3 of front-side slit 3a. In order to achieve this, it is more preferable that, in the flow soldering, the distance between support end portion 3e6 of rear-side support portion 4b at the rearmost portion and rearmost support end portion 3e5 of the other front-side support portion 4a in the transfer direction of main substrate 1 be shorter than the distance between one end portion 3e1 of rear-side slit 3b at the rearmost portion and inner end portion 3e3 of the other front-side slit 3a.

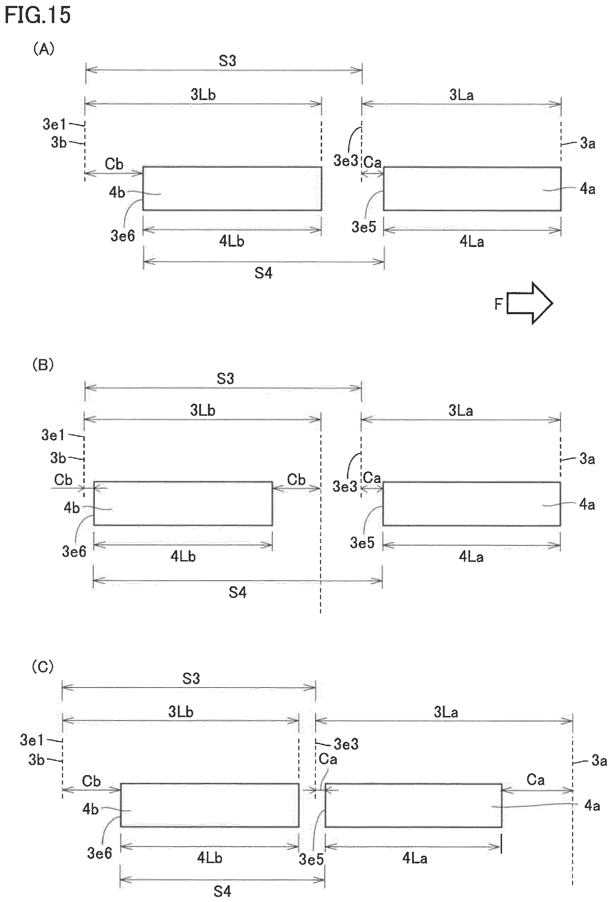

With reference to Fig. 15 (A), when 4La = 4Lb and 3Lb > 3La are satisfied as in the example of the present embodiment in Fig. 13 for example, the distance S4 between rearmost support end portion 3e6 of rear-side support portion 4b and rearmost support end portion 3e5 of front-side support portion 4a is shorter than the distance S3 between one end portion 3e1 of rear-side slit 3b and inner end portion 3e3 of front-side slit 3a. In this case, clearance Cb greater than clearance Ca allows restraint point 7 to be formed at inner end portion 3e3.

With reference to Fig. 15 (B), distance S4 is longer than distance S3 in this example. In this case, even with clearance Cb greater than clearance Ca, restraint point 7 is formed at one end portion 3e1. In this case, the distance from restraint point 7 to the solder joint portion at the electrode remotest from restraint point 7 is longer than in Fig. 15 (A). However, since slit divider 5 and support-portion divider 6 lie between restraint point 7 and the solder joint portion remotest from restraint point 7, the thermal distortion at the maximum distortion soldering portion can be at least smaller than that of the comparative example in Fig. 10.

With reference to Fig. 15 (C), distance S4 is shorter than distance S3 in this example. In this case, even with clearance Cb smaller than clearance Ca, restraint point 7 can be formed at inner end portion 3e3.

### Embodiment 2

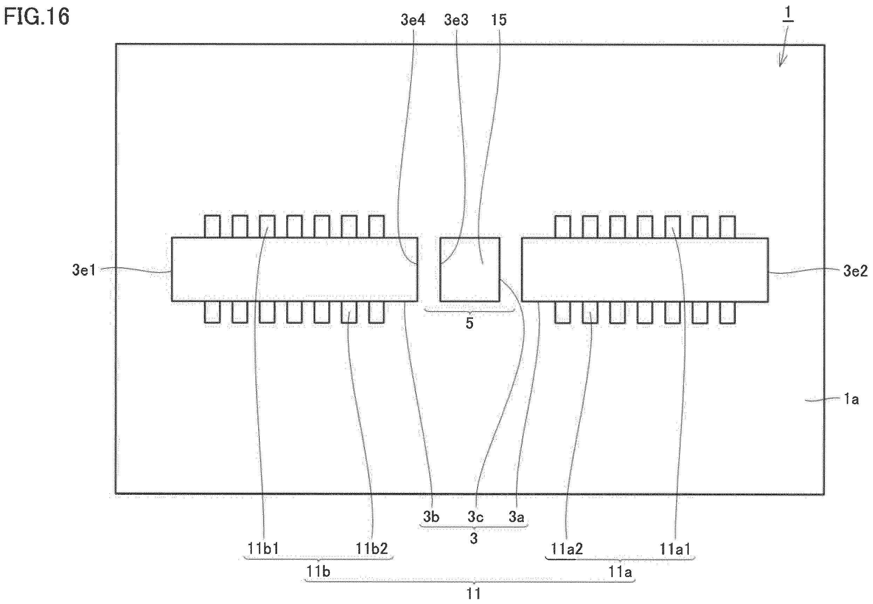

Fig. 16 to Fig. 19 respectively correspond to Fig. 4 to Fig. 7 in embodiment 1. A method for manufacturing a three-dimensional printed wiring board in the present embodiment is described with reference to Fig. 16 to Fig. 19. In the following, the components identical to those of embodiment 1 are identically denoted, and redundant explanation is not repeated.

With reference to Fig. 16, main substrate 1 prepared in the present embodiment is basically the same as main substrate 1 in embodiment 1 shown in Fig. 4, but is different in that slit 3 includes not only front-side slit 3a and rear-side slit 3b but also an intermediate slit 3c between the slits 3a and 3b. As shown in Fig. 16, intermediate slit 3c is substantially equal to front-side slit 3a and rear-side slit 3b in dimension with respect to the width direction of main substrate 1, but is shorter than front-side slit 3a and rear-side slit 3b in dimension with respect to the extending direction of main substrate 1. Main substrate 1 in the present embodiment, however, is not limited to such a mode.

In Fig. 16, one end portion 3e1 and the other end portion 3e2 with respect to the extending direction of the entire row of a plurality of (three) arranged slits 3 are respectively the left end portion of rear-side slit 3b in Fig. 16 and the right end portion of front-side slit 3a in Fig. 16, as in embodiment 1. Inner end portion 3e3 in Fig. 16 is the same as that of embodiment 1 in that it is a point located between one end portion 3e1 and the other end portion 3e2, but is the one-side end portion (the left side in Fig. 16) of intermediate slit 3c. Inner end portion 3e4 is the other-side end portion (the right side in Fig. 16) of rear-side slit 3b.

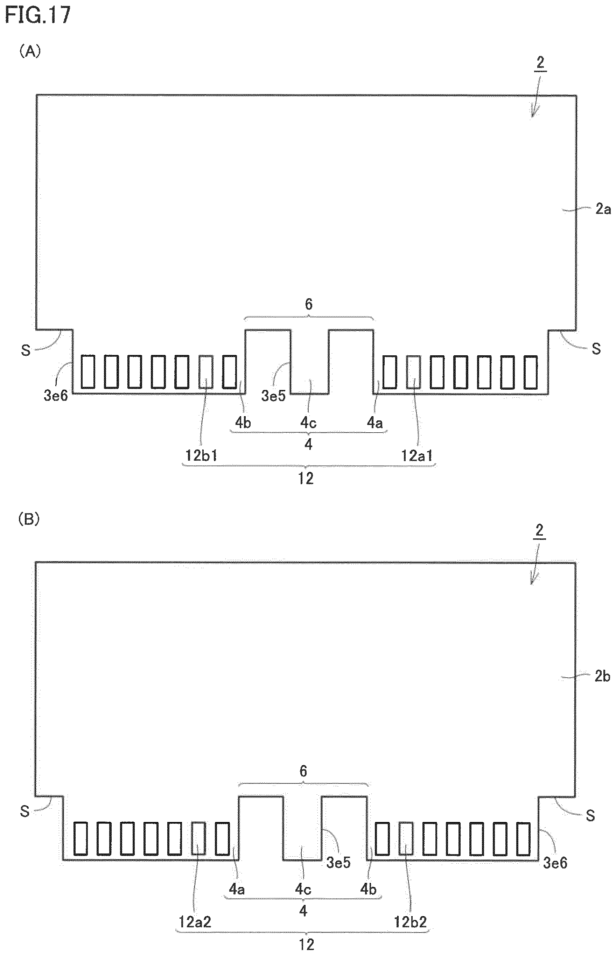

With reference to Fig. 17 (A), (B), standing substrate 2 prepared in the present embodiment is basically the same as standing substrate 2 in embodiment 1 shown in Fig. 5, but is different in that support portion 4 includes not only front-side support portion 4a and rear-side support portion 4b but also an intermediate support portion 4c between support portions 4a and 4b. Intermediate support portion 4c is substantially equal to front-side support portion 4a and rear-side support portion 4b in dimension with respect to the thickness direction of standing substrate 2, but is shorter than front-side support portion 4a and rear-side support portion 4b in dimension with respect to the extending direction of standing substrate 2. Standing substrate 2 in the present embodiment, however, is not limited to such a mode.

In Fig. 17, support end portion 3e5 is the end portion at one extreme end (the left end in Fig. 17) with respect to the extending direction of intermediate support portion 4c, and support end portion 3e6 is the end portion at the one extreme end (the left end in Fig. 17) with respect to the extending direction of rear-side support portion 4b. However, each of support end portions 3e5, 3e6 may be considered as the end portion at the other extreme end (the right end in Fig. 17).

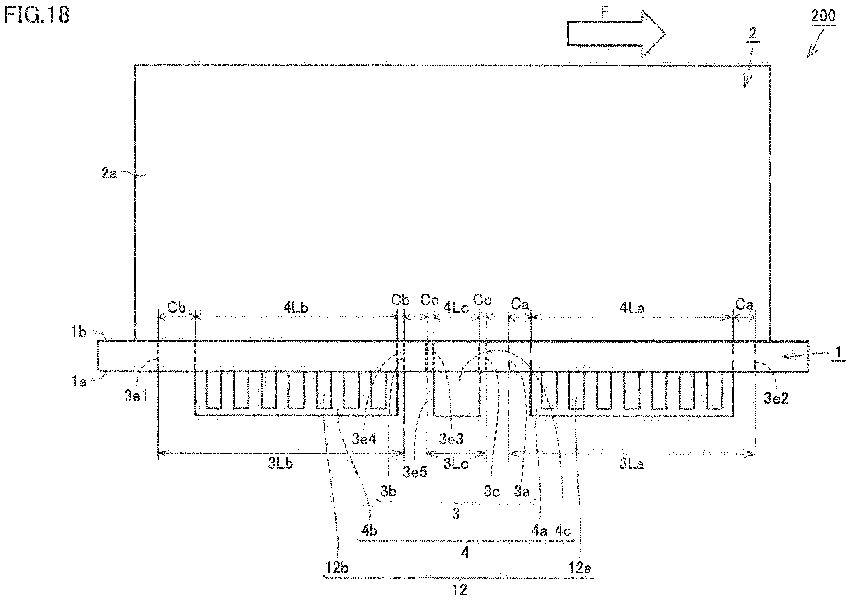

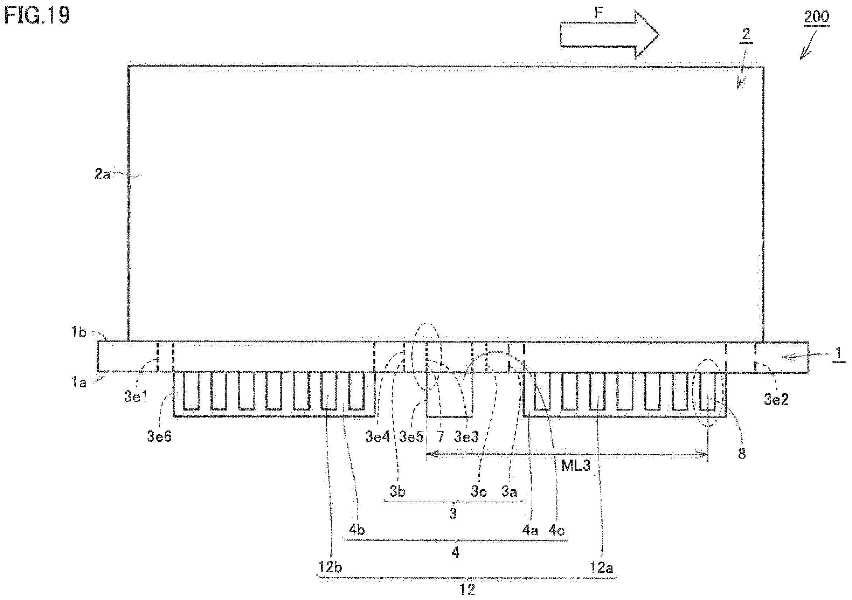

With reference to Fig. 18, main substrate 1 and standing substrate 2 shown in Fig. 16 and Fig. 17 are placed in such a manner that their extending direction is along the direction indicated by arrow F. Main substrate 1 and standing substrate 2 are transferred by flow soldering while keeping this position. The transfer is performed while front-side slit 3a is located on the front side and rear-side slit 3b is located on the rear side with respect to the transfer direction. This is the same as embodiment 1. The state of main substrate 1 and standing substrate 2 after being transferred is shown in Fig. 19.

As shown in Fig. 18, when support portion 4 is initially inserted in slit 3, not only clearance Ca = 3La - 4La and clearance Cb = 3Lb - 4Lb, but also a clearance Cc = 3Lc-4Lc are produced, clearance Cc being the difference between dimension 3Lc in the extending direction of intermediate slit 3c and dimension 4Lc in the extending direction of intermediate support portion 4c. Here, 3La = 3Lb and 4La = 4Lb are satisfied.

In the present embodiment, clearance Cb and clearance Ca are greater than clearance Cc. In Fig. 18, it is preferable that the distance between frontmost support end portion 3e5 with respect to the extending direction of intermediate support portion 4c and frontmost support end portion 3e6 with respect to the extending direction of rear-side support portion 4b be equal to the distance between the frontmost end portion with respect to the extending direction of intermediate slit 3c and frontmost inner end portion 3e4 with respect to the extending direction of rear-side slit 3b.

Fig. 19 shows a state, as seen in the same direction as Fig. 2, in which main substrate 1 and standing substrate 2 have been transferred by the flow soldering, which is an embodiment of a finished product of three-dimensional printed wiring board 200. With reference to Fig. 19, such a configuration causes standing substrate 2 to flow rearward relative to main substrate 1 with respect to transfer direction F. As a result, restraint point 7 is formed at which inner end portion 3e3 of intermediate slit 3c and the rearmost portion (support end portion 3e5 in Fig. 19) of front-side support portion 4a are in contact with each other, and at which slit 3 in main substrate 1 and standing substrate 2 are in contact with, restrained by, and fixed to each other. This restraint point 7 is formed at a position other than one end portion 3e1 and the other end portion 3e2 opposite to one end portion 3e1 with respect to the extending direction of the entire row of a plurality of slits 3 arranged in the extending direction.

As described above, three-dimensional printed wiring board 200 in the present embodiment includes intermediate slit 3c formed between rear-side slit 3b on the one end portion 3e1 side and front-side slit 3a on the other end portion 3e2 side, among a plurality of divided slits 3 in main substrate 1. Also, the present embodiment includes intermediate support portion 4c to be inserted in intermediate slit 3c. Intermediate support portion 4c is formed between rear-side support portion 4b on the one end portion 3e1 side and front-side support portion 4a on the other end portion 3e2 side, among a plurality of divided support portions 4 in standing substrate 2. Restraint point 7 is formed by contact between intermediate slit 3c and intermediate support portion 4c.

Next, the advantageous effects of the present embodiment are described.

Even with additional intermediate slit 3c and intermediate support portion 4c as in the present embodiment, forming restraint point 7 by contact between intermediate slit 3c and intermediate support portion 4c can reduce the distance between restraint point 7 and maximum distortion soldering portion 8 with respect to the extending direction, as in embodiment 1 (see Fig. 12), as compared to the case in which slit 3 and support portion 4 are not divided. By controlling the dimension and clearance of each portion as described above, restraint point 7 can be formed by contact between intermediate slit 3c and intermediate support portion 4c.

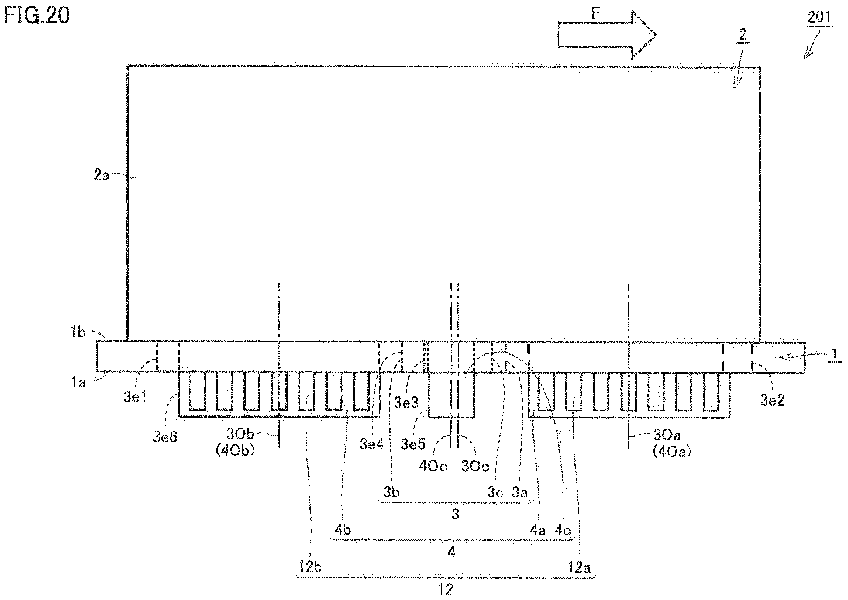

Next, with reference to Fig. 20, a variation of the present embodiment is described.

Fig. 20 shows a mode of flow soldering in a variation of the present embodiment, similarly to Fig. 18. With reference to Fig. 20, a three-dimensional printed wiring board 201 in the variation of the present embodiment is basically the same in configuration as three-dimensional printed wiring board 200 in the present embodiment described above. Thus, identical components are identically denoted, and the explanation thereof is not repeated.

In three-dimensional printed wiring board 201, clearance Cb is greater than clearance Cc, and center line 3Ob of rear-side slit 3b and center line 4Ob of rear-side support portion 4b with respect to the extending direction of slit 3 are aligned. At this time, intermediate support portion 4c is formed is such a manner that center line 4Oc of intermediate support portion 4c is displaced rearward in the transfer direction indicated by arrow F, relative to center line 3Oc of intermediate slit 3c with respect to the extending direction of slit 3. Divided slits 3 and support portions 4 are designed with such a positional relationship.

With this configuration, restraint point 7 can be formed reliably at inner end portion 3e3. This is because, in this case, the distance between rearmost support end portion 3e5 of intermediate support portion 4c and rearmost support end portion 3e6 of rear-side support portion 4b is shorter than the distance between rearmost inner end portion 3e3 of intermediate slit 3c and rearmost one end portion 3e1 of rear-side slit 3b, thus making it impossible for rearmost support end portion 3e6 of rear-side support portion 4b to be in contact with one end portion 3e1.

In order to form restraint point 7 reliably at inner end portion 3e3 in the present embodiment, it is more preferable that, in the flow soldering, the distance between support end portion 3e6 of rear-side support portion 4b at the rearmost portion and rearmost support end portion 3e5 of intermediate support portion 4c, other than rear-side support portion 4b, in the transfer direction of main substrate 1 be shorter than the distance between one end portion 3e1 of rear-side slit 3b at the rearmost portion and inner end portion 3e3 of intermediate slit 3c, other than rear-side support portion 4b.

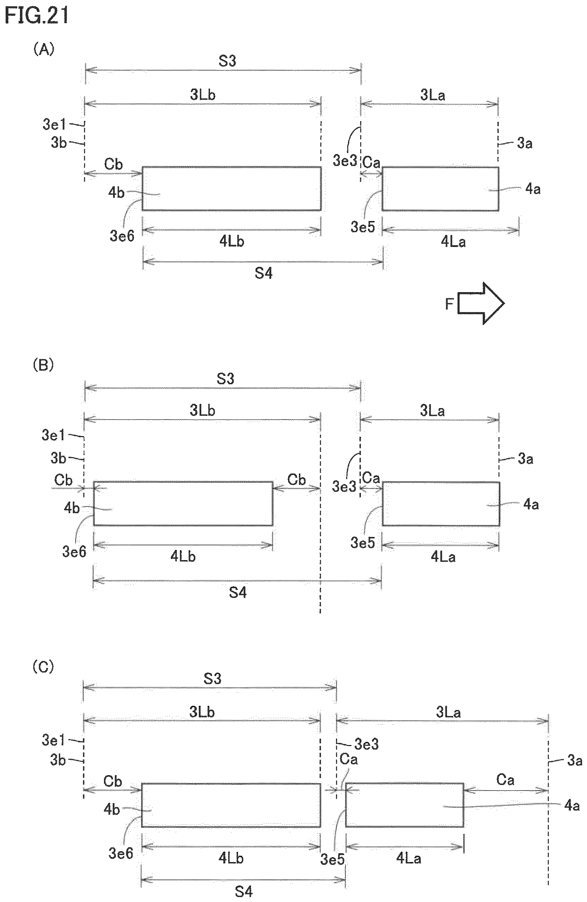

Fig. 21 (A), (B), (C) summarizes the present embodiment. Fig. 21 (A), (B), (C) includes intermediate support portion 4c instead of front-side support portion 4a of Fig. 15(A), (B), (C), and includes intermediate slit 3c instead of front-side slit 3a of Fig. 15 (A), (B), (C). In other respects, Fig. 21 (A), (B), (C) is basically the same as Fig. 15 (A), (B), (C), and thus the detailed explanation is not repeated. In the case of Fig. 21 (A), (C), restraint point 7 can be formed at inner end portion 3e3; whereas in the case of Fig. 21 (B), restraint point 7 is formed at one end portion 3e1.

### Embodiment 3

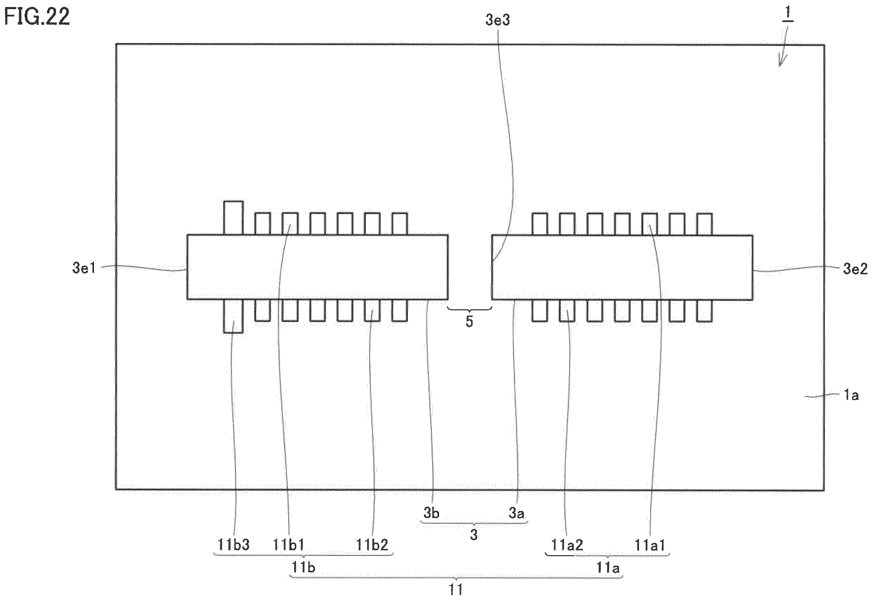

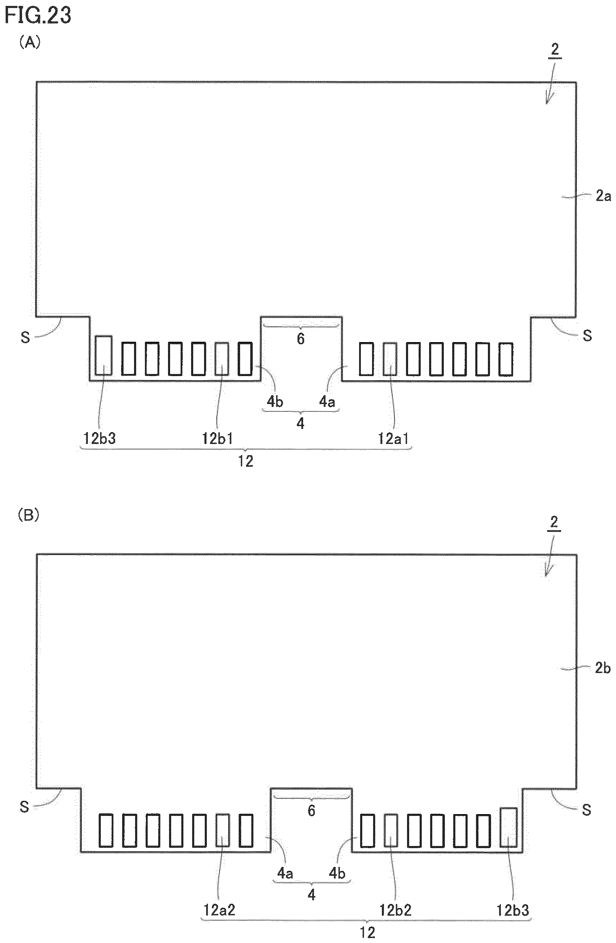

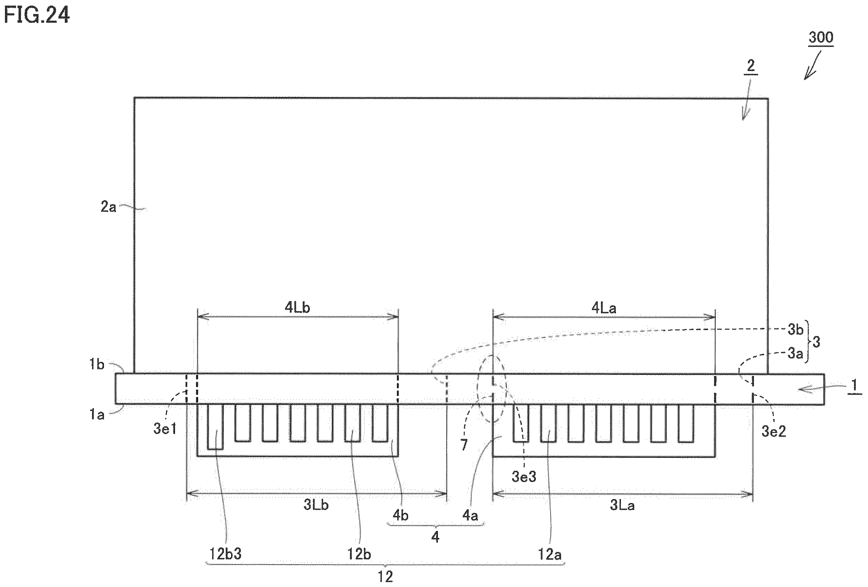

Fig. 22 and Fig. 23 respectively correspond to Fig. 4 and Fig. 5 in embodiment 1, and Fig. 24 corresponds to Fig. 7 in embodiment 1. With reference to Fig. 22, Fig. 23, and Fig. 24, a three-dimensional printed wiring board 300 and a method for manufacturing the same in the present embodiment basically conform to three-dimensional printed wiring board 100 and the method for manufacturing the same in embodiment 1 shown in Fig. 4, Fig. 5, and Fig. 7. Thus, identical components are identically denoted, and the explanation thereof is not repeated. In the manufacturing method in the present embodiment, however, the rearmost electrode at rear-side slit 3b among a plurality of main substrate electrodes 11 adjacent to rear-side slit 3b (the slit located on the rear side in the transfer direction at the time of flow soldering) is formed as a main substrate enlarged electrode 11b3, which is larger in plane area than the other main substrate electrodes 11. Similarly, rearmost standing substrate electrode 12 on rear-side support portion 4b is formed as a standing substrate enlarged electrode 12b3, which is larger in plane area than the other standing substrate electrodes 12. Main substrate enlarged electrode 11b3 is larger in plane area than the other main substrate electrodes 11 (front-side main substrate electrodes 11a and rear-side main substrate electrodes 11b) preferably by 20% or more. Similarly, standing substrate enlarged electrode 12b3 is larger than the other standing substrate electrodes 12 (front-side standing substrate electrodes 12a and rear-side standing substrate electrodes 12b) preferably by 20% or more.

That is, in three-dimensional printed wiring board 300 of a finished product in Fig. 24, main substrate enlarged electrode 11b3 closest to rearmost one end portion 3e1 with respect to the transfer direction, among a plurality of main substrate electrodes 11, is larger in plane area than the other main substrate electrodes 11. Also, standing substrate enlarged electrode 12b3 closest to one end portion 3e1, among a plurality of standing substrate electrodes 12, is larger in plane area than the other main substrate electrodes 11.

Next, the advantageous effects of the present embodiment are described.

As seen from Fig. 11, main substrate electrode 11 and standing substrate electrode 12 adjacent to the rearmost portion or one end portion 3e1 with respect to the transfer direction are the electrodes that will form maximum distortion soldering portion 8 when solder-joined. That is, these electrodes will be subjected to the greatest thermal distortion caused by temperature cycle under the use environment of three-dimensional printed wiring board 300. Accordingly, in the present embodiment, main substrate electrode 11 and standing substrate electrode 12 that are closest to one end portion 3e1 and thus will be subjected to the greatest thermal distortion are respectively formed as main substrate enlarged electrode 11b3 and standing substrate enlarged electrode 12b3. Accordingly, since the electrodes are enlarged, the length of the actually solder-joined portion of maximum distortion soldering portion 8 is made longer. Therefore, if a crack is generated in maximum distortion soldering portion 8 by thermal distortion, the risk of absolute breakage of soldering portion 8 due to extension of the crack is reduced. This is because enlarged electrodes can tolerate longer cracks before being absolutely broken. Thus, the life of maximum distortion soldering portion 8 can be prolonged.

If the thermal distortion is greatest at the joint portion between main substrate electrode 11 and standing substrate electrode 12 closest to the other end portion 3e2, main substrate electrode 11 and standing substrate electrode 12 closest to the other end portion 3e2 may be enlarged in plane area.

In the example shown above, main substrate enlarged electrode 11b3 and standing substrate enlarged electrode 12b3 are applied to embodiment 1 where slit 3 and support portion 4 are each divided into two parts. However, main substrate enlarged electrode 11b3 and standing substrate enlarged electrode 12b3 may also be applied to embodiment 2 where slit 3 and support portion 4 are each divided into three parts.

### Embodiment 4

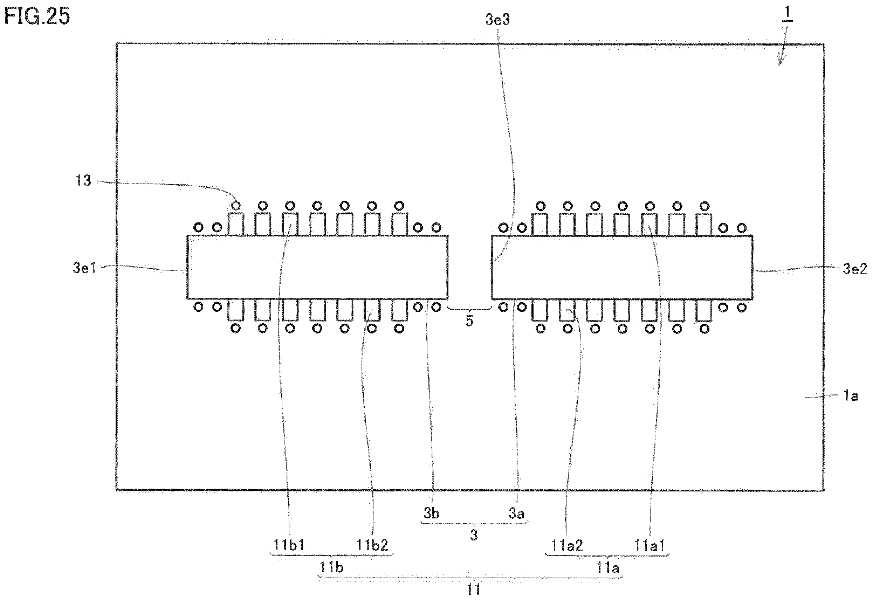

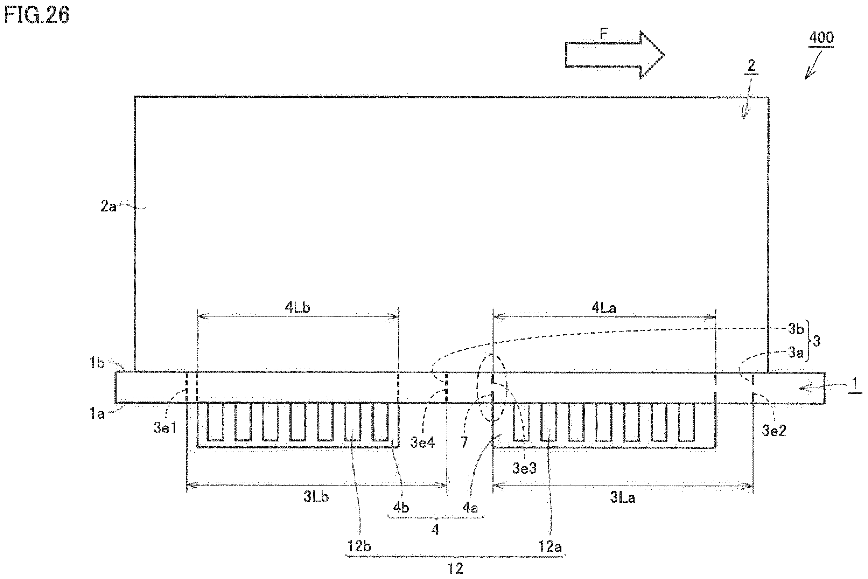

Fig. 25 and Fig. 26 respectively correspond to Fig. 4 and Fig. 7 in embodiment 1. A method for manufacturing a three-dimensional printed wiring board in the present embodiment is described with reference to Fig. 25 to Fig. 26. In the following, the components identical to those of embodiment 1 are identically denoted, and redundant explanation is not repeated.

With reference to Fig. 25 and Fig. 26, a three-dimensional printed wiring board 400 and a method for manufacturing the same in the present embodiment basically conform to three-dimensional printed wiring board 100 and the method for manufacturing the same in embodiment 1 shown in Fig. 4 and Fig. 7. Also, main substrate 1 prepared in the present embodiment is basically the same as main substrate 1 in embodiment 1 shown in Fig. 4. However, main substrate 1 in the present embodiment includes a plurality of via holes 13 formed in the region adjacent to a plurality of main substrate electrodes 11, the via holes 13 extending through main substrate 1 from one first main surface 1a to the other first main surface 1b. In this respect, the present embodiment is different in configuration from embodiment 1 where no via hole 13 is formed. In Fig. 25, via holes 13 are formed in the region adjacent to and on the outer side relative to a plurality of arranged main substrate electrodes 11.

Via holes 13 are through holes formed for the purpose of electrical connection between the layers. Each of a plurality of via holes 13 has an inner wall with a conductor film 14 formed thereon. Conductor film 14 is a copper thin film. Conductor film 14 is higher in thermal conductivity than the material (glass epoxy base material, or resin material such as epoxy resin) that constitutes main substrate 1 in which conductor film 14 is formed.

Although not shown, standing substrate 2 in three-dimensional printed wiring board 400 is the same in configuration as standing substrate 2 in embodiment 1 shown in Fig. 5.

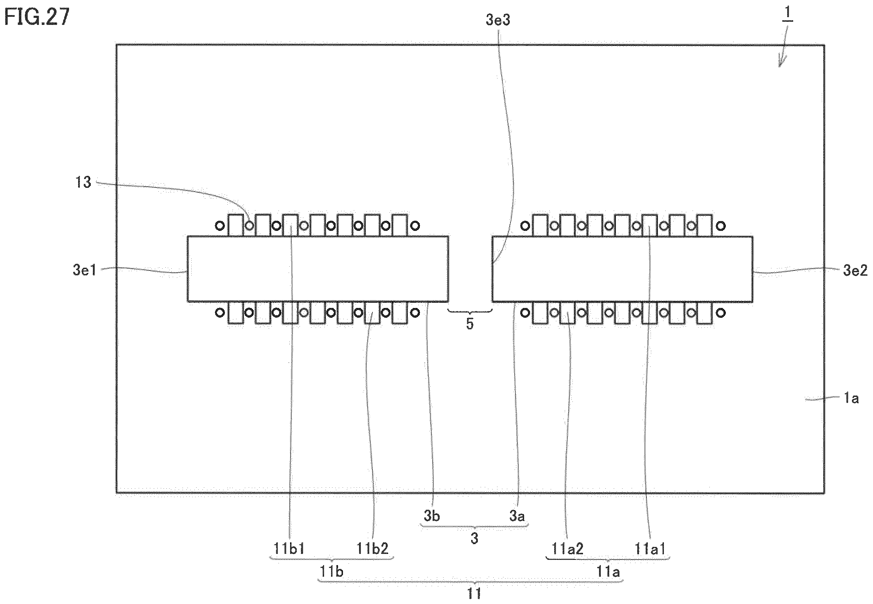

Next, a variation of the present embodiment is described with reference to Fig. 27 to Fig. 30. Fig. 27 in a first variation of the present embodiment corresponds to Fig. 4 in embodiment 1. With reference to Fig. 27, in the first variation of the present embodiment, via holes 13 in main substrate 1 are formed in the region adjacent to a plurality of main substrate electrodes 11, i.e., the region between a pair of adjacent main substrate electrodes 11 among a plurality of arranged main substrate electrodes 11. Via holes 13 are formed also on the outer side of the electrodes disposed on one extreme end portion and the other extreme end portion with respect to the direction in which a plurality of main substrate electrodes 11 are arranged. Thus, in Fig. 27, via holes 13 are formed in the region adjacent to a plurality of main substrate electrodes 11.

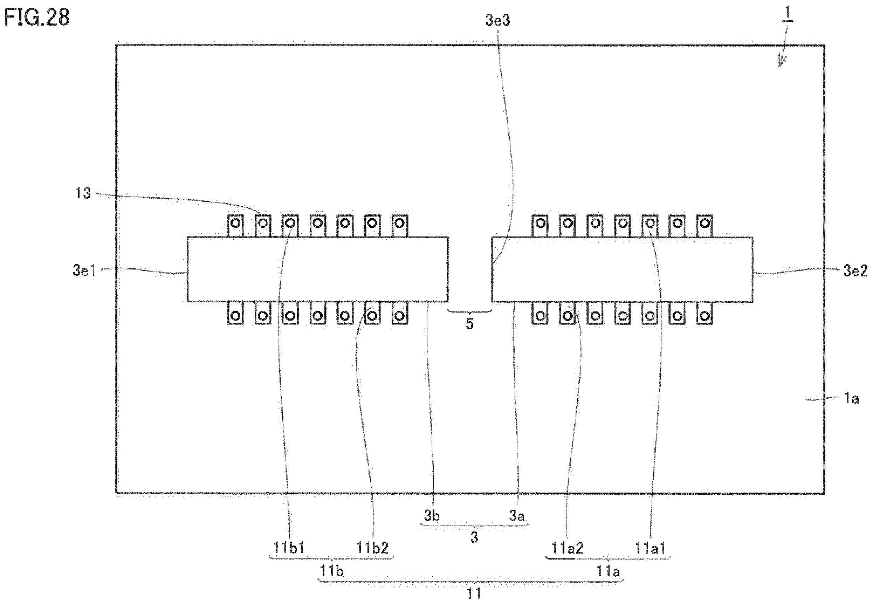

Fig. 28 in a second variation of the present embodiment corresponds to Fig. 4 in embodiment 1. With reference to Fig. 28, in the second variation of the present embodiment, via holes 13 in main substrate 1 coincide with main substrate electrodes 11 (extend through main substrate electrodes 11). In this case, the parts of via holes 13 are hollow with no main substrate electrode 11. Thus, in Fig. 28, via holes 13 are adjacent to the region where a plurality of main substrate electrodes 11 are formed. That is, in Fig. 28, via holes 13 are formed in the region adjacent to a plurality of main substrate electrodes 11.

In both examples in Fig. 27 and Fig. 28, standing substrate 2 is the same in configuration as standing substrate 2 in embodiment 1 shown in Fig. 5. Further, in both examples in Fig. 27 and Fig. 28, the manner in which main substrate 1 and standing substrate 2 are combined into three-dimensional printed wiring board 400 is the same as Fig. 26.

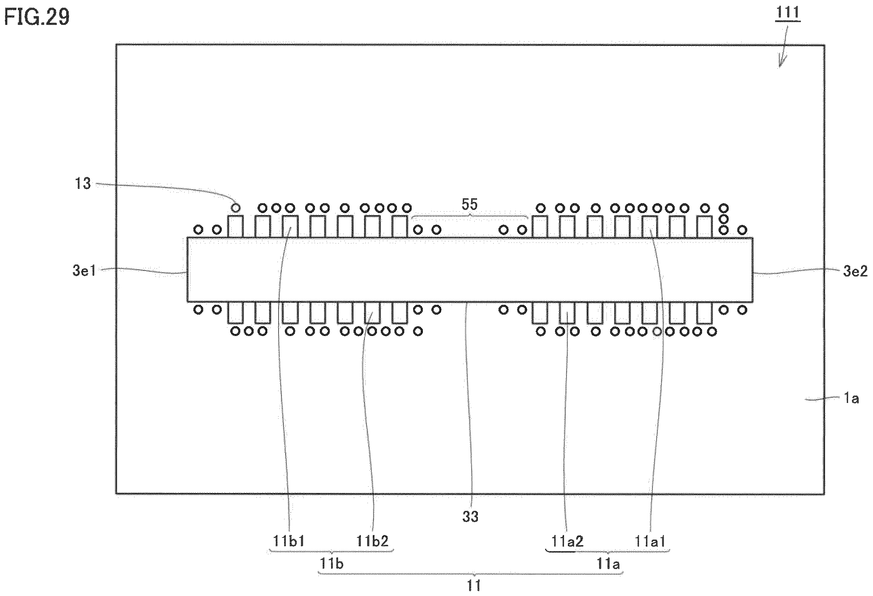

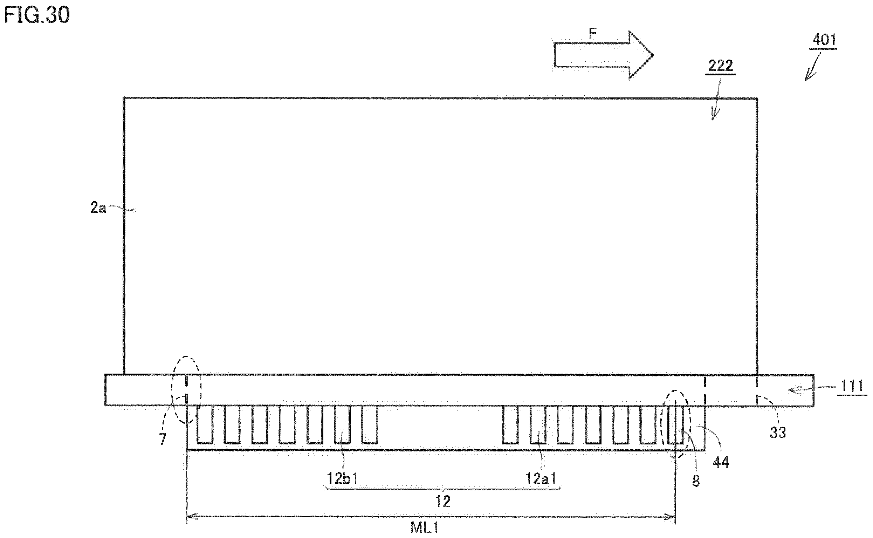

Fig. 29 and Fig. 30 in a third variation of the present embodiment respectively correspond to Fig. 4 and Fig. 7 in embodiment 1. With reference to Fig. 29 and Fig. 30, as in the comparative example for embodiment 1 shown in Fig. 8 to Fig. 10, each of slit 33 and support portion 44 in a three-dimensional printed wiring board 401 in the third variation of the present embodiment is not divided into a plurality of parts but is continuous with respect to its extending direction. However, three-dimensional printed wiring board 401 includes a plurality of via holes 13 at the same position as those of three-dimensional printed wiring board 400 in Fig. 25 and Fig. 26. The example in Fig. 29 and Fig. 30 uses a standing substrate having the same configuration as standing substrate 222 in Fig. 9.

With a plurality of via holes 13 formed as in the present embodiment, certain advantageous effects described below are achieved though slit 33 and support portion 44 are not divided into a plurality of parts but continuous with respect to their extending direction as in the comparative example for embodiment 1. The advantageous effects of the present embodiment are hereinafter described.

For example, in embodiments 1 to 3, main substrate 1 and standing substrate 2 are immersed in molten solder in the flow soldering. During this immersion, the heat causes main substrate 1 to warp in the direction intersecting the direction along first main surfaces 1a, 1b. Main substrate 1 is soldered in this warped state. This is due to a temperature difference between the surfaces of main substrate 1 that are immersed and not immersed in the molten solder; and also due to a difference in coefficient of thermal expansion between the surfaces of main substrate 1 that are immersed and not immersed in the molten solder. In this case, there is a difference between the amount of solder adhering to main substrate electrodes 11 formed on main substrate 1 with a large warp, and the amount of solder adhering to main substrate electrodes 11 formed on main substrate 1 with a small warp. This causes a difference in life before breakage between main substrate electrodes 11 with a large warp and main substrate electrodes 11 with a small warp. That is, the difference in life before breakage among a plurality of main substrate electrodes 11 leads to lower reliability of the joint portion between main substrate 1 and standing substrate 2. Such a problem is particularly noticeable when the dimension of slit 3 in the long-side direction is longer for densification.

In view of the above, main substrate 1 in the present embodiment includes a plurality of via holes 13 formed in the region adjacent to a plurality of main substrate electrodes 11, the via holes 13 extending through main substrate 1 from one first main surface 1a to the other first main surface 1b. Each via hole 13 has an inner wall with a conductor film 14, such as copper, formed thereon. Conductor film 14 is made of a material higher in thermal conductivity than a resin material, the main material of main substrate 1. This reduces a temperature difference between wetting portions and non-wetting portions when main substrate 1 is immersed in molten solder. This is due to heat transfer with a high thermal conductivity from one first main surface 1a to the other first main surface 1b. This can equalize, among main substrate electrodes 11, the amount of solder constituting the electrodes. Thus, a three-dimensional printed wiring board excellent in reliability of the joint portion with solder SD (see Fig. 3) can be provided.

The variations shown in Fig. 27 to Fig. 30 achieve the same advantageous effects as three-dimensional printed wiring board 400 shown in Figs. 25 and 26. That is, the configuration with via holes 13 in the present embodiment is applicable to any configuration in which a standing substrate is inserted in a slit in a main substrate and flow-soldered thereto. Thus, it may be applied to three-dimensional printed wiring board 401 in Fig. 29 and Fig. 30 where slit 33 and support portion 44 are not divided into a plurality of parts.

In the above, a case in which via holes 13 are formed in the configuration of embodiment 1 is described. However, a case in which via holes 13 are formed may also be applied to the configuration of embodiments 2 and 3.

The embodiments and the examples described in the embodiments can be combined as appropriate, if technically compatible.

It should be understood that the embodiments disclosed herein are by way of example in every respect, without limitation. The scope of the present invention is defined not by the above description but by the terms of the claims, and is intended to include any modification within the meaning and scope equivalent to the terms of the claims.

### REFERENCE SIGNS LIST

- 1, 111: main substrate;
- 1a: one first main surface;
- 1b: the other first main surface;
- 2, 222: standing substrate;
- 2a: one second main surface;
- 2b: the other second main surface;
- 3, 33: slit;
- 3a: front-side slit;
- 3b: rear-side slit;
- 3c: intermediate slit;
- 3e1: one end portion;
- 3e2: the other end portion;
- 3e3, 3e4: inner end portion;
- 3e5, 3e6: support end portion;
- 3Oa, 3Ob, 3Oc, 4Oa, 4Ob, 4Oc: center line;
- 4, 44: support portion;
- 4a: front-side support portion;
- 4b: rear-side support portion;
- 4c: intermediate support portion;
- 5: slit divider;
- 6: support-portion divider;
- 7: restraint point;
- 8: maximum distortion soldering portion;
- 11: main substrate electrode;
- 11a: front-side main substrate electrode;
- 11a1: one-side front-side main substrate electrode;
- 11a2: other-side front-side main substrate electrode;
- 11b: rear-side main substrate electrode;
- 11b1: one-side rear-side main substrate electrode;
- 11b2: other-side rear-side main substrate electrode;
- 11b3: main substrate enlarged electrode;
- 12: standing substrate electrode;
- 12a: front-side standing substrate electrode;
- 12a1: one-side front-side standing substrate electrode;
- 12a2: other-side front-side standing substrate electrode;
- 12b: rear-side standing substrate electrode;
- 12b1: one-side rear-side standing substrate electrode;
- 12b2: other-side rear-side standing substrate electrode;
- 12b3: standing substrate enlarged electrode;
- 13: via hole;
- 14: conductor film;
- 55, 66: divider counterpart region;
- 100, 101, 102, 200, 201, 300, 400, 401: three-dimensional printed wiring board;
- Ca, Cb: clearance;
- SD: solder

## Claims

1. A three-dimensional printed wiring board comprising:
- a main substrate including one first main surface and the other first main surface opposite to the one first main surface, the main substrate having a slit extending from the one first main surface to the other first main surface; and
- a standing substrate including one second main surface and the other second main surface opposite to the one second main surface, the standing substrate being inserted in the slit so as to intersect the main substrate, the standing substrate being joined to the main substrate,
- the one first main surface having a plurality of first electrodes formed thereon along an extending direction of the slit, each of the one second main surface and the other second main surface having a plurality of second electrodes formed thereon along the extending direction, the plurality of first electrodes and the plurality of second electrodes being joined with solder,
- the standing substrate including a support portion inserted in the slit,
- each of the slit and the support portion being divided into a plurality of parts with respect to the extending direction,
- a restraint point at which the slit and the standing substrate are in contact with each other being located on any of end portions of a pair of the slits adjacent to each other among a row of a plurality of the slits arranged in the extending direction.

2. The three-dimensional printed wiring board according to claim 1, wherein
the first electrodes are formed in a plurality of pairs on both of one side and the other side, opposite to the one side, of the slit with respect to a width direction intersecting the extending direction of the slit,
the second electrodes are formed in a plurality of pairs on both of the one second main surface and the other second main surface of the standing substrate, and
the first electrodes on the one side and the second electrodes on the one second main surface are electrically joined to each other with the solder so as to have different electric potentials, and the first electrodes on the other side and the second electrodes on the other second main surface are electrically joined to each other with the solder so as to have different electric potentials.

3. The three-dimensional printed wiring board according to claim 1 or 2, wherein each of the plurality of support portions is inserted in a corresponding one of the plurality of slits,
the plurality of slits include a first slit adjacent to one end portion, and a second slit other than the first slit,
the plurality of support portions include a first support portion adjacent to the one end portion, and a second support portion other than the first support portion, the first support portion being inserted in the first slit, and
a dimension difference with respect to the extending direction between the first slit and the first support portion is different from a dimension difference with respect to the extending direction between the second slit and the second support portion.

4. The three-dimensional printed wiring board according to any one of claims 1 to 3, further comprising:
- an intermediate slit formed between the slit adjacent to one end portion and the slit adjacent to the other end portion, among the plurality of divided slits in the main substrate; and
- an intermediate support portion formed between the support portion adjacent to the one end portion and the support portion adjacent to the other end portion, among the plurality of divided support portions in the standing substrate, the intermediate support portion being inserted in the intermediate slit, wherein
the restraint point is formed by contact between the intermediate slit and the intermediate support portion.

5. The three-dimensional printed wiring board according to claim 3 or 4, wherein
a first electrode and a second electrode closest to the one end portion, among the plurality of first electrodes and the plurality of second electrodes, are larger in plane area than a first electrode and a second electrode other than the first electrode and the second electrode closest to the one end portion, respectively.

6. A method for manufacturing a three-dimensional printed wiring board, the method comprising:
- preparing a main substrate including one first main surface and the other first main surface opposite to the one first main surface, the main substrate having a slit extending from the one first main surface to the other first main surface;
- preparing a standing substrate including one second main surface and the other second main surface opposite to the one second main surface, the standing substrate being configured to be joined to the main substrate; and
- inserting the standing substrate in the slit in the main substrate, and joining a plurality of first electrodes and a plurality of second electrodes by flow soldering, the plurality of first electrodes being formed on the one first main surface of the main substrate along an extending direction of the slit, the plurality of second electrodes being formed on each of the one second main surface and the other second main surface of the standing substrate along the extending direction,
the standing substrate including a support portion to be inserted in the slit,
each of the slit and the support portion being divided into a plurality of parts with respect to the extending direction,
in the flow soldering, the standing substrate and the main substrate are transferred while the main substrate and the standing substrate are placed in such a manner that the extending direction is along a transfer direction of the main substrate and the standing substrate, thereby forming a restraint point, at which the slit and the standing substrate are in contact with each other, on any of end portions of a pair of the slits adjacent to each other among a row of a plurality of the slits arranged in the extending direction.

7. The method for manufacturing a three-dimensional printed wiring board according to claim 6, wherein
each of the plurality of support portions is inserted in a corresponding one of the plurality of slits, and
the plurality of slits include a first slit and a second slit other than the first slit, the first slit being located at a rearmost portion among the plurality of slits in a direction in which the main substrate is transferred in the flow soldering,
the plurality of support portions include a first support portion and a second support portion other than the first support portion, the first support portion being located at the rearmost portion among the plurality of support portions in the flow soldering, the first support portion being inserted in the first slit, and
a dimension difference with respect to the extending direction between the first slit and the first support portion is larger than a dimension difference with respect to the extending direction between the second slit and the second support portion.

8. A three-dimensional printed wiring board comprising:
- a main substrate including one first main surface and the other first main surface opposite to the one first main surface, the main substrate having a slit extending from the one first main surface to the other first main surface; and
- a standing substrate including one second main surface and the other second main surface opposite to the one second main surface, the standing substrate being inserted in the slit so as to intersect the main substrate, the standing substrate being joined to the main substrate,
the one first main surface having a plurality of first electrodes formed thereon along an extending direction of the slit, each of the one second main surface and the other second main surface having a plurality of second electrodes formed thereon along the extending direction, the plurality of first electrodes and the plurality of second electrodes being joined with solder,
the standing substrate including a support portion inserted in the slit,
the main substrate having a plurality of through holes in a region adjacent to the plurality of first electrodes, the plurality of through holes extending through the main substrate from the one first main surface to the other first main surface, each of the plurality of through holes having an inner wall with a conductor film formed thereon.
